# EUROPEAN PATENT APPLICATION

(11) **EP 4 199 177 A2**
(43) Date of publication of application: **21.06.2023**
(21) Application number: 22213045.2
(22) Date of filing: 13.12.2022
(51) Int. Cl.: H01M 10/42, H01M 10/48, H01M 50/519

(54) **INTELLIGENT MULTI-CELL BATTERY ASSEMBLY AND METHOD**

(30) Priority: 14.12.2021 US 202163289335 P; 07.12.2022 US 202218076468
(71) Applicant: VOLVO CAR CORPORATION, 405 31 Göteborg (SE)
(72) Inventor: FORSSELL, Jonas, 405 31 GÖTEBORG (SE); GONG, Angela, 405 31 GÖTEBORG (SE); BJÖRKHOLTZ, Jonas, 405 31 GÖTEBORG (SE)
(74) Representative: Kransell & Wennborg KB

(57) **Abstract**

A battery assembly, including: a plurality of battery cells each including a pair of poles; a printed circuit board (PCB) disposed adjacent to the plurality of battery cells and electrically coupled to a pole of the pair of poles of each of the plurality of battery cells; a plurality of switches disposed on the PCB each electrically coupled between the pair of poles of an associated battery cell; and a controller disposed on the PCB and electrically coupled to the plurality of switches; wherein the controller and the plurality of switches are operable for controlling the voltage provided by each of the plurality of battery cells. The PCB and the plurality of switches are electrically coupled to the pole of the pair of poles of each of the plurality of battery cells via a plurality of bus bars disposed one or more of above and below the PCB.

## Description

### TECHNICAL FIELD

The present disclosure relates generally to the automotive and battery energy storage (BES) fields.

More particularly, the present disclosure relates to an intelligent multi-cell battery assembly and method, with cell or multi-cell integrated monitoring and switching, for use in an electric vehicle (EV), a hybrid electric vehicle (HEV), or other similar electrical system.

### BACKGROUND

Currently, an electric driveline (e.g., an electric driveline used in an EV or HEV) is based on a battery with a direct current (DC) voltage of approximately 370V. Many systems are designed around this battery to protect and control the battery. Auxiliary units are used to generate alternating current (AC) voltage to run motors and charge the battery, for example. All these systems are complex and expensive and are a source of errors.

At present, there are a number of different types of battery packs including multiple batteries and/or cells. Some example problems with such battery packs include: (a) they are always on, that is, they always have a live voltage (e.g., approximately 400V); and/or (b) they provide a constant voltage and therefore use the auxiliary units described above to provide fluctuating voltage (e.g., AC voltage) and/or lower voltage (e.g., 12V, 48V, etc.). In addition, there are a variety of existing centralized battery management systems (BMSs) that can be used in many different systems. Some example problems with existing BMSs include: (a) they utilize a set of sensor cables and/or submodules that add complexity, size, and/or cost; (b) they only monitor cell parameters (e.g., temperature, pressure, etc.); (c) they are not integrated inside the cell; and/or (d) they do not provide integrated switch functionality.

Thus, multi-cell battery technologies have been developed that utilize multiple intelligent battery cells or clusters of battery cells, each including individualized monitoring, control, and switching, to provide flexible, granular DC and AC capabilities with reduced component complexity and form factor and enhanced functionality. Each intelligent battery cell or cluster of battery cells acts substantially independently, utilizing a synchronized clock and fast, decentralized control and switching to rapidly connect to and disconnect from the collective, such that the flexible, granular DC and AC power supply can be provided on demand, with superior cell redundancy, among other advantages. Further, such a collective can closely match a power grid used for rapid charging, for example. The result is a robust, flexible, responsive BES with reduced component complexity and form factor.

The present background is provided as non-limiting illustrative context only. It will be readily apparent to those of ordinary skill in the art that the concepts and principles of the present disclosure may be applied in other contexts equally.

### SUMMARY

The present summary is intended to provide a basic understanding of one or more embodiments of the present disclosure. This summary is not intended to identify key or critical elements, or delineate any limiting scope of the particular embodiments. Its sole purpose is to present concepts in a simplified form as a prelude to the more detailed description that follows. In one or more illustrative embodiments described herein, systems, assemblies, devices, computer-implemented methods, and/or computer program products facilitate an intelligent multi-cell battery assembly and method with integrated monitoring and switching.

In multiple embodiments, the assemblies of the present disclosure include one or more battery cells including an active battery cell material. An internal circuit is integrated into each battery cell or cluster of battery cells and coupled to the active battery cell material and includes one or more switches coupled to battery cell poles of each battery cell and a processor that operates the one or more switches to provide a defined value of electric potential at the battery cell poles.

Thus, the multi-cell battery technology of the present disclosure utilizes a multi-level inverter scheme that enables the replacement of a large number of components utilizing a single-printed circuit board (PCB) design, including high-current, low-voltage switches that are cooled, in part, by the associated cell volume. This scheme is optimized for performance and cost, and may be applied to each cell individually or to a cluster of cells, as is described in greater detail herein below. Where applicable, additional connections and functionalities can be utilized for the balancing of cells, which may be arranged into modules, packs, or the like. As provided herein, design is simplified by replacing a busbar, which promotes ease of implementation and modularity avoids affecting gas evacuation from the cells, for example. The busbar design of the present disclosure enhances thermal, electrical, electromagnetic compatibility (EMC), and cost performance, while minimizing form factor. Only incremental changes to existing battery packs are required and the design provided may be used in CellToPack and CellToBody schemes, where battery modules are effectively eliminated.

In one illustrative embodiment, the present disclosure provides a battery assembly, including: a battery cell including a pair of poles; a printed circuit board disposed adjacent to the battery cell and electrically coupled to a pole of the pair of poles; an elongated busbar electrically coupled between the printed circuit board and another pole of the pair of poles; a switch disposed on the printed circuit board and electrically coupled between the pair of poles; and a controller disposed on the printed circuit board and electrically coupled to the switch; wherein the controller and the switch are operable for controlling the voltage provided by the battery cell.

In another illustrative embodiment, the present disclosure provides a battery assembly, including: a pair of battery cells each including a pair of poles; a printed circuit board disposed adjacent to the pair of battery cells and electrically coupled to a pole of the pair of poles of each of the pair of battery cells; a pair of switches disposed on the printed circuit board each electrically coupled between the pair of poles of an associated battery cell of the pair of battery cells; and a controller disposed on the printed circuit board and electrically coupled to the pair of switches; wherein the controller and the pair of switches are operable for controlling the voltage provided by each of the pair of battery cells. The battery assembly further includes a short busbar electrically coupled between another pole of the pair of poles of each of the pair of battery cells and electrically coupled to the printed circuit board. The printed circuit board and the pair of switches are electrically coupled to the pole of the pair of poles of each of the pair of battery cells via a plurality of bus bars disposed one or more of above and below the printed circuit board.

In a further illustrative embodiment, the present disclosure provides a battery assembly, including: a plurality of battery cells each including a pair of poles; a printed circuit board disposed adjacent to the plurality of battery cells and electrically coupled to a pole of the pair of poles of each of the plurality of battery cells; a plurality of switches disposed on the printed circuit board each electrically coupled between the pair of poles of an associated battery cell of the plurality of battery cells; and a controller disposed on the printed circuit board and electrically coupled to the plurality of switches; wherein the controller and the plurality of switches are operable for controlling the voltage provided by each of the plurality of battery cells. The battery assembly further includes a short busbar electrically coupled between another pole of the pair of poles of selected of the plurality of battery cells and electrically coupled to the printed circuit board. The printed circuit board and the plurality of switches are electrically coupled to the pole of the pair of poles of each of the plurality of battery cells via a plurality of bus bars disposed one or more of above and below the printed circuit board. The battery assembly further includes a short busbar electrically coupled between the pole of the pair of poles of selected of the plurality of battery cells. Optionally, the battery assembly further includes an insulating layer disposed on an upper surface of the short busbar electrically coupled between the pole of the pair of poles of selected of the plurality of battery cells. Optionally, the plurality of switches are disposed in a module disposed adjacent to the printed circuit board. The module is disposed within or adjacent to a frame manufactured in the printed circuit board. The module includes one or more conductive flanges disposed on either side thereof adapted to make electrical connections with the plurality of switches. Selected of the one or more conductive flanges include a bent conductive flange adapted to electrically connect the plurality of switches to the pole of the pair of poles of selected of the plurality of battery cells and provide clearance between the module and the pole of the pair of poles of other of the plurality of battery cells.

### DESCRIPTION OF THE DRAWINGS

The present disclosure is illustrated and described with reference to the various drawings, in which like reference numbers are used to denote like assembly components/method steps, as appropriate, and in which:
FIG. 1 is a perspective view of an illustrative, non-limiting device that can facilitate an intelligent battery cell with integrated monitoring and switching in accordance with one or more embodiments described herein;
FIG. 2 is a perspective view of another illustrative, non-limiting device that can facilitate an intelligent battery cell with integrated monitoring and switching in accordance with one or more embodiments described herein;
FIG. 3 illustrates an example, non-limiting circuit that can facilitate an intelligent battery cell with integrated monitoring and switching in accordance with one or more embodiments described herein;
FIG. 4 illustrates example, non-limiting operation modes that can facilitate an intelligent battery cell with integrated monitoring and switching in accordance with one or more embodiments described herein;
FIG. 5 illustrates example, non-limiting electrical diagrams that can facilitate an intelligent battery cell with integrated monitoring and switching in accordance with one or more embodiments described herein;
FIG. 6 illustrates an example, non-limiting diagram that can facilitate an intelligent battery cell with integrated monitoring and switching in accordance with one or more embodiments described herein;
FIG. 7 illustrates an example, non-limiting plot that can facilitate an intelligent battery cell with integrated monitoring and switching in accordance with one or more embodiments described herein;
FIG. 8 illustrates an example, non-limiting diagram that can facilitate an intelligent battery cell with integrated monitoring and switching in accordance with one or more embodiments described herein;
FIG. 9 illustrates example, non-limiting electronic systems that can facilitate an intelligent battery cell with integrated monitoring and switching in accordance with one or more embodiments described herein;
FIGS. 10A-10C illustrate a top view and a cross-sectional side view, respectively, of an example, non-limiting electronic system that can facilitate an intelligent battery cell with integrated monitoring and switching in accordance with one or more embodiments described herein, and an example, non-limiting plot corresponding to the electronic system of FIGS. 10A and 10B, respectively;
FIGS. 11A-11C illustrate example, non-limiting existing (e.g., prior art) devices and an example, non-limiting device that can facilitate an intelligent battery cell with integrated monitoring and switching in accordance with one or more embodiments described herein;
FIG. 12 illustrates an example, non-limiting system that can facilitate an intelligent battery cell with integrated monitoring and switching in accordance with one or more embodiments described herein;
FIG. 13 illustrates an example, non-limiting circuit that can facilitate an intelligent battery cell with integrated monitoring and switching in accordance with one or more embodiments described herein;
FIG. 14 illustrates an example, non-limiting circuit that can facilitate an intelligent battery cell with integrated monitoring and switching in accordance with one or more embodiments described herein;
FIG. 15 illustrates an example, non-limiting diagram that can facilitate an intelligent battery cell with integrated monitoring and switching in accordance with one or more embodiments described herein;
FIG. 16 illustrates an example, non-limiting circuit that can facilitate an intelligent battery cell with integrated monitoring and switching in accordance with one or more embodiments described herein;
FIG. 17 illustrates an example, non-limiting wire diagram that can facilitate an intelligent battery cell with integrated monitoring and switching in accordance with one or more embodiments described herein;
FIG. 18 illustrates an example, non-limiting wire diagram that can facilitate an intelligent battery cell with integrated monitoring and switching in accordance with one or more embodiments described herein;
FIG. 19 illustrates a perspective view of an example, non-limiting device that can facilitate an intelligent battery cell with integrated monitoring and switching in accordance with one or more embodiments described herein;
FIG. 20 is a perspective view of one illustrative embodiment of the intelligent battery assembly of the present disclosure, utilizing an individual integrated control and switching system;
FIG. 21 is a perspective view of one illustrative embodiment of the intelligent multi-cell battery assembly of the present disclosure, utilizing a shared integrated control and switching system;
FIG. 22 is a perspective view of another illustrative embodiment of the intelligent multi-cell battery assembly of the present disclosure, utilizing a shared integrated control and switching system;
FIGS. 23A and 23B are perspective views of the intelligent multi-cell battery assembly of FIG. 21 in various states of assembly;
FIGS. 24A-24C are perspective views of the intelligent multi-cell battery assembly of FIG. 22 in various states of assembly;
FIGS. 25A and 25B are perspective and cross-sectional end views of a further illustrative embodiment of the intelligent multi-cell battery assembly of the present disclosure, utilizing a shared integrated control and switching system in a component version;
FIGS. 26A and 26B are perspective and cross-sectional end views of a further illustrative embodiment of the intelligent multi-cell battery assembly of the present disclosure, utilizing a shared integrated control and switching system in an embedded version; and
FIGS. 27A-27C are perspective and cross-sectional end views and a circuit diagram of a further illustrative embodiment of the intelligent multi-cell battery assembly of the present disclosure, utilizing a shared integrated control and switching system in a module version.

### DETAILED DESCRIPTION

The following detailed description is merely illustrative and is not intended to limit the embodiments and/or the application or uses of the embodiments. Furthermore, there is no intention to be bound by any expressed or implied information presented in the preceding background or summary sections, or in this detailed description section.

One or more illustrative embodiments are now described with reference to the various drawings, wherein like reference numbers are used to refer to like elements throughout. In the following description, for purposes of explanation, numerous specific details are set forth in order to provide a more thorough understanding of the one or more embodiments. It is evident, however, in various cases, that the one or more embodiments can be practiced without these specific details. It will be understood that when an element is referred to as being "coupled" to another element, it can describe one or more different types of coupling including, but not limited to, chemical coupling, communicative coupling, electrical coupling, electromagnetic coupling, operative coupling, optical coupling, physical coupling, mechanical coupling, thermal coupling, and/or another type of coupling.

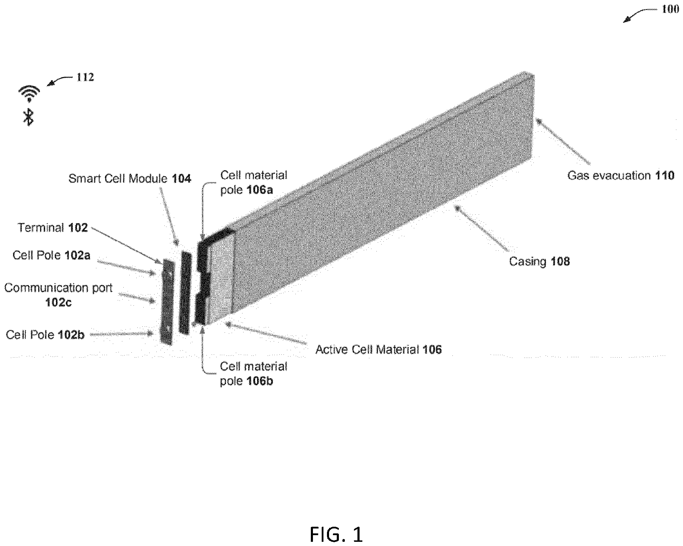

FIG. 1 is a perspective view of an example, non-limiting device 100 that can facilitate an intelligent battery cell with integrated monitoring and switching in accordance with one or more embodiments described herein. Device 100 can include a battery device and/or a battery cell device that can be implemented in a variety of different electronic systems. In an embodiment, device 100 can be implemented as a single battery device and/or a single battery cell device. In another embodiment, device 100 can be implemented as a single battery device and/or a single battery cell device in a battery pack (also referred to as a battery array, battery bank, power bank, etc.). In another embodiment, device 100 can be implemented as a single battery device and/or a single battery cell device in a battery pack used in an electric driveline of an EV or HEV.

As illustrated in the example embodiment depicted in FIG. 1, device 100 can include a terminal 102 having cell poles 102a, 102b and/or a communication port 102c. In this embodiment, device 100 can further include a smart cell module 104 that can be coupled to terminal 102 and/or cell poles 102a, 102b and further coupled to an active cell material 106 and/or cell material poles 106a, 106b of active cell material 106. In this embodiment, device 100 can further include a casing 108 that can encapsulate one or more components of device 100. For example, casing 108 can encapsulate active cell material 106, cell material poles 106a, 106b, and/or smart cell module 104. In some embodiments, casing 108 can also encapsulate (e.g., partially or fully) terminal 102 and/or cell poles 102a, 102b. In the example embodiment illustrated in FIG. 1, device 100 can further include a gas evacuation 110 that can be formed on a side of device 100 and/or casing 108.

Terminal 102 can include a battery terminal. Cell poles 102a, 102b can include battery cell poles (e.g., a positive battery terminal and a negative battery terminal). Terminal 102 and/or cell poles 102a, 102b can include an electrically conducting material that can facilitate the transfer of electric current and/or voltage to and/or from smart cell module 104 and/or active cell material 106 (e.g., via cell material poles 106a, 106b).

Communication port 102c can include a communication port that can enable a wired connection of device 100 (e.g., a wired connection of smart cell module 104) to another device (e.g., a computer, a controller (e.g., microcontroller), a transceiver, a processor, a memory, etc.). Although the example embodiment illustrated in FIG. 1 includes communication port 102c that can facilitate a wired connection to device 100 (e.g., to smart cell module 104), it should be appreciated that the present disclosure is not so limiting. For example, in some embodiments, as described below, device 100 and/or one or more components thereof (e.g., smart cell module 104) can include a transmitter, a receiver, and/or a transceiver that can facilitate wireless communication over a network (e.g., the Internet, etc.) between device 100 (e.g., smart cell module 104) and another device (e.g., a computing and/or communication device of an EV or HEV including device 100, a computing resource in a cloud computing environment (e.g., a virtual machine, a virtual computer, a server, a memory, etc.), and/or another device).

Smart cell module 104 can include an intelligent (e.g., "smart") separator (e.g., interface) between cell poles 102a, 102b (e.g., external cell poles) of terminal 102 and cell material poles 106a, 106b (e.g., internal cell poles) of active cell material 106. Smart cell module 104 can include an internal circuit of device 100. Smart cell module 104 can include an integrated circuit (IC) that can be formed on a substrate (e.g., a silicon (Si) substrate, etc.) using one or more fabrication techniques and/or materials described below.

Fabrication of device 100 and/or smart cell module 104 can include multi- step sequences of, for example, photolithographic and/or chemical processing steps that facilitate gradual creation of electronic-based systems, devices, components, and/or circuits in a semiconducting and/or a superconducting device (e.g., an IC). For instance, smart cell module 104 can be fabricated on a substrate (e.g., a silicon (Si) substrate, etc.) by employing techniques including, but not limited to: photolithography, microlithography, nanolithography, nanoimprint lithography, photomasking techniques, patterning techniques, photoresist techniques (e.g., positive-tone photoresist, negative-tone photoresist, hybrid-tone photoresist, etc.), etching techniques (e.g., reactive ion etching (RIE), dry etching, wet etching, ion beam etching, plasma etching, laser ablation, etc.), evaporation techniques, sputtering techniques, plasma ashing techniques, thermal treatments (e.g., rapid thermal anneal, furnace anneals, thermal oxidation, etc.), chemical vapor deposition (CVD), atomic layer deposition (ALD), physical vapor deposition (PVD), molecular beam epitaxy (MBE), electrochemical deposition (ECD), chemical-mechanical planarization (CMP), backgrinding techniques, and/or another technique for fabricating an IC.

Device 100 and/or smart cell module 104 can be fabricated using various materials. For example, device 100 and/or smart cell module 104 can be fabricated using materials of one or more different material classes including, but not limited to: conductive materials, semiconducting materials, superconducting materials, dielectric materials, polymer materials, organic materials, inorganic materials, non-conductive materials, and/or another material that can be utilized with one or more of the techniques described above for fabricating an IC.

Although the example embodiment illustrated in FIG. 1 depicts smart cell module 104 positioned vertically in device 100 between terminal 102 and active cell material 106, it should be appreciated that the present disclosure is not so limiting. For example, in another embodiment, smart cell module 104 can be positioned (e.g., vertically, horizontally, etc.) in and/or on, for instance, casing 108, active cell material 106, a battery pack including device 100, and/or at another location in and/or on device 100 and/or such a battery pack including device 100.

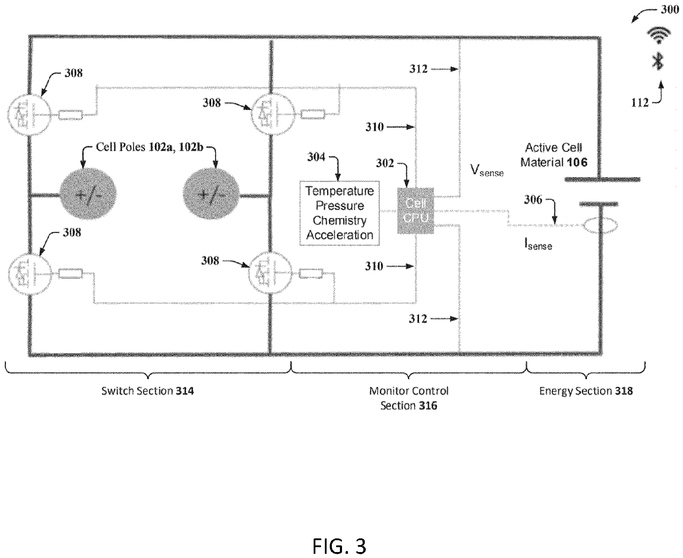

Smart cell module 104 can be implemented in device 100 to form an intelligent battery cell that can include one or more integrated monitoring components and/or switches that can facilitate different parameter monitoring and/or collection operations and/or different operating modes of device 100 in accordance with one or more embodiments of the present disclosure described herein. For example, smart cell module 104 can include one or more sensors (not illustrated in FIG. 1) that can monitor and/or collect parameter data of device 100 and/or one or more components thereof. For instance, smart cell module 104 can include one or more sensors (e.g., one or more sensors 306 described below with reference to FIG. 3) that can monitor and/or collect parameter data of device 100 and/or active cell material 106 including, but not limited to: temperature; pressure (e.g., swelling); chemistry (e.g., chemistry on electrolyte to monitor aging); acceleration (e.g., to sense a crash of, for instance, an electric vehicle including device 100); current (e.g., current flowing into and/or out of device 100 and/or active cell material 106); voltage (e.g., voltage potential across cell material poles 106a, 106b of active cell material 106); and/or other parameter data of device 100 and/or active cell material 106. In these examples, smart cell module 104 can further include one or more switches (e.g., one or more switches 308 described below with reference to FIG. 3) that can include, for instance, metal-oxide-semiconductor field-effect transistor (MOSFET) switches that can facilitate different operating modes of device 100 (e.g., off, positive, negative, bypass, etc.) in accordance with one or more embodiments of the present disclosure described herein.

To facilitate such parameter monitoring and/or different operating modes of device 100 described above, smart cell module 104 can include a processor (not illustrated in FIG. 1), a memory (not illustrated in FIG. 1), one or more sensors, and/or one or more switches. For example, as described below with reference to FIG. 3, smart cell module 104 can include a processor 302 (e.g., a central processing unit (CPU), a microprocessor, etc.), a memory 304, one or more sensors 306 (e.g., temperature sensor, pressure sensor, etc.), and/or one or more switches 308 (e.g., MOSFET switches) that can enable the parameter monitoring and/or different operating modes of device 100 described above.

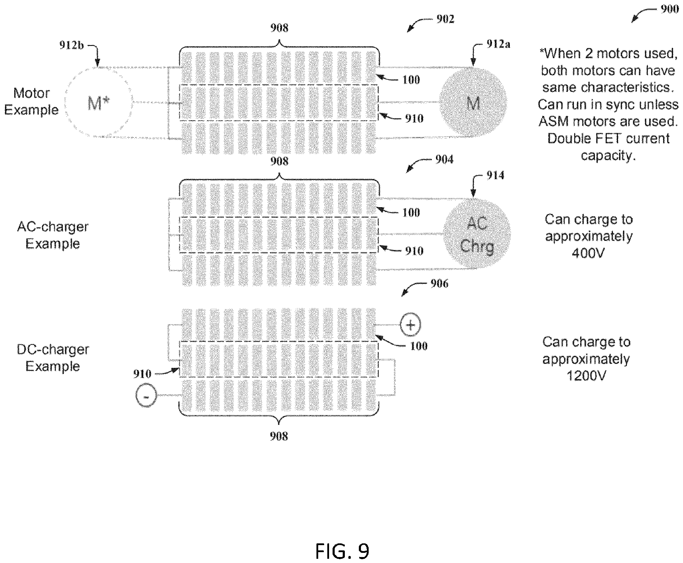

In some embodiments, device 100 and/or smart cell module 104 can include a switch controller (not illustrated here) that can control (e.g., via processor 302) the operation of such one or more switches 308 (e.g., MOSFET switches) to facilitate such different operating modes of device 100 described above. In some embodiments, a battery pack (e.g., battery pack 908 described below with reference to FIG. 9) that can include multiple devices 100 and/or smart cell modules 104 can include such a switch controller described above. In these embodiments, such a switch controller in such a battery pack can control (e.g., via processor 302 and/or another processor) the operation of such one or more switches 308 (e.g., MOSFET switches) in each device 100 to facilitate such different operating modes of each device 100 described above.

Device 100 can include a modular component that can function and/or be controlled independent of all other battery devices and/or battery cell devices (e.g., other devices 100) that can be in a battery pack (e.g., battery pack 908 described below with reference to FIG. 9). Therefore, it should be appreciated that one or more devices 100 in such a battery pack can be removed and/or replaced without affecting the structure and/or functionality of the battery pack and/or any other devices 100 in the battery pack.

Active cell material 106 can include active battery cell material such as, for instance, a battery cell (also referred to as a "cell"). Active cell material 106 can include a single battery cell or, in some embodiments, multiple individual battery cells that can be positioned inside casing 108 according to a variety of patterns (e.g., vertically, horizontally, etc.). Active cell material 106 can include any type of battery cell material such as, for instance, a lithium battery cell material, a lithium ion (Li-Ion) battery cell material, a lithium metal battery cell material, a lithium sulphur (Li-S) battery cell material, a molten salt (Na- NiCl₂) battery cell material, a nickel metal hydride (Ni-MH) battery cell material, a lead acid battery cell material, and/or another type of battery cell material.

Gas evacuation 110 can include a device and/or structure that can facilitate the release of gas from casing 108 that can be generated by active cell material 106 (e.g., during charging, discharging, etc.). For example, gas evacuation 110 can include a vent, a port, a hole, a plate, a flap, a valve (e.g., a pressure relief valve, a one-way valve, a check valve, etc.), and/or another device and/or structure that can facilitate the release of gas from casing 108.

Smart cell module 104 can include any type of component, machine, device, facility, apparatus, and/or instrument that can include a processor and/or can be capable of effective and/or operative communication with a wired and/or wireless network. All such embodiments are envisioned. For example, smart cell module 104 can include a computing device, a general-purpose computer, a special-purpose computer, a quantum computing device (e.g., a quantum computer), an IC, a system on a chip (SOC), and/or another type of device.

Smart cell module 104 can be coupled (e.g., communicatively, electrically, operatively, optically, etc.) to one or more external systems, sources, and/or devices (e.g., classical and/or quantum computing devices, communication devices, etc.). For example, smart cell module 104 can be coupled via communication port 102c to one or more external systems, sources, and/or devices using a data cable (e.g., High-Definition Multimedia Interface (HDMI), recommended standard (RS) 232, Ethernet cable, etc.) and/or one or more wired networks described below.

In some embodiments, smart cell module 104 can be coupled (e.g., communicatively, electrically, operatively, optically, etc.) to one or more external systems, sources, and/or devices (e.g., classical and/or quantum computing devices, communication devices, etc.) via a network 112. Network 112 can include one or more wired and/or wireless networks, including, but not limited to, a cellular network, a wide area network (WAN) (e.g., the Internet), and/or a local area network (LAN). For example, smart cell module 104 can communicate with one or more external systems, sources, and/or devices, for instance, computing devices using network 112, which can include virtually any desired wired or wireless technology, including but not limited to: powerline ethernet, wireless fidelity (Wi-Fi), BLUETOOTH^{®}, fiber optic communications, global system for mobile communications (GSM), universal mobile telecommunications system (UMTS), worldwide interoperability for microwave access (WiMAX), enhanced general packet radio service (enhanced GPRS), third generation partnership project (3GPP) long term evolution (LTE), third generation partnership project 2 (3GPP2) ultra mobile broadband (UMB), high speed packet access (HSPA), Zigbee and other 802.XX wireless technologies and/or legacy telecommunication technologies, Session Initiation Protocol (SIP), ZIGBEE^{®}, RF4CE protocol, WirelessHART protocol, 6LoWPAN (IPv6 over Low power Wireless Area Networks), Z-Wave, an ANT, an ultra-wideband (UWB) standard protocol, and/or other proprietary and non-proprietary communication protocols. In such an example and as described above, smart cell module 104 can thus include hardware (e.g., a CPU, a transceiver, a decoder, an antenna, quantum hardware, a quantum processor, etc.), software (e.g., a set of threads, a set of processes, software in execution, quantum pulse schedule, quantum circuit, quantum gates, etc.) or a combination of hardware and software that facilitates communicating information between smart cell module 104 and external systems, sources, and/or devices (e.g., computing devices, communication devices, etc.). The software may include processor-executed instructions stored in a memory associated with a non-transitory computer-readable medium.

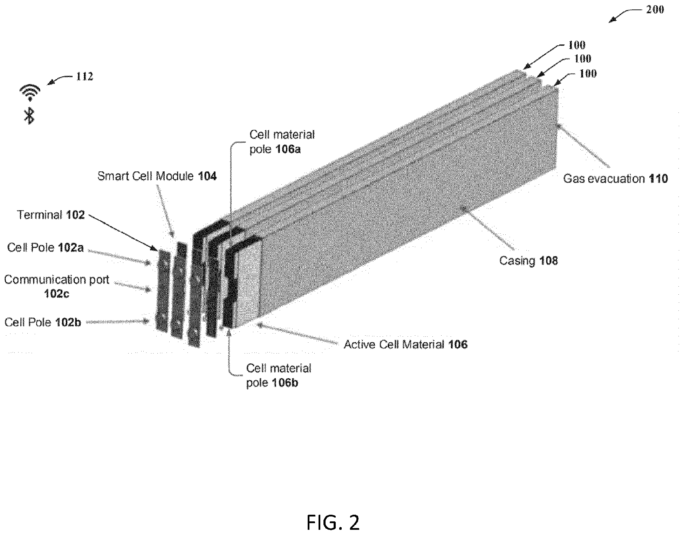

FIG. 2 illustrates a perspective view of an example, non-limiting device 200 that can facilitate an intelligent battery cell with integrated monitoring and switching in accordance with one or more embodiments described herein. Repetitive description of like elements and/or processes employed in respective embodiments is omitted for sake of brevity.

Device 200 illustrated in FIG. 2 can include an example, non-limiting alternative embodiment of device 100 described above with reference to FIG. 1. For example, device 200 can include a battery pack having one or more devices 100 (e.g., three as depicted in FIG. 2). In another example, device 200 can include a battery pack having one or more devices 100 (e.g., three), where such a battery pack can be implemented in an electronic system such as, for instance, an electric driveline of an EV or HEV.

FIG. 3 illustrates an example, non-limiting circuit 300 that can facilitate an intelligent battery cell with integrated monitoring and switching in accordance with one or more embodiments described herein. Repetitive description of like elements and/or processes employed in respective embodiments is omitted for sake of brevity.

Circuit 300 can include an electrical circuit representation of device 100. To facilitate such parameter monitoring and/or different operating modes of device 100 described above with reference to FIG. 1, smart cell module 104 can include a processor 302 (denoted as "Cell CPU" in FIG. 3), a memory 304, one or more sensors 306, and/or one or more switches 308 as illustrated in the example embodiment depicted in FIG. 3. In some embodiments, processor 302 can include a CPU that can include memory 304.

As illustrated by circuit 300 in the example embodiment depicted in FIG. 3, smart cell module 104 can include multiple sections including, but not limited to, a switch section 314, a monitor and/or control section 316, an energy section 318, and/or another section. Switch section 314 can include an H-bridge electronic circuit having multiple switches 308 (e.g., four switches 308 including four MOSFET switches). Monitor and/or control section 316 can include processor 302, memory 304, and/or one or more sensors 306. To facilitate various monitoring and/or control functions of smart cell module 104 and/or device 100, smart cell module 104, processor 302, memory 304, one or more sensors 306, and/or one or more switches 308 can use (e.g., draw) electric energy (e.g., electric power, electric current, electric voltage) from active cell material 106. For example, as illustrated in the example embodiment depicted in FIG. 3, processor 302 and/or memory 304 can be coupled to active cell material 106 via wire traces 312 (e.g., integrated metal wires, striplines, microstrips, etc.), which can enable smart cell module 104, processor 302, memory 304, one or more sensors 306, and/or one or more switches 308 to draw electric energy (e.g., electric power, electric current, electric voltage) from active cell material 106. Energy section 318 can include active cell material 106 and cell material poles 106a, 106b, which can enable the transfer of electric energy (e.g., electric current, electric voltage, etc.) into and out of active cell material 106, smart cell module 104, and/or device 100.

As smart cell module 104 and/or one or more components thereof (e.g., processor 302, memory 304, one or more sensors 306, one or more switches 308, etc.) can draw electric energy (e.g., electric power) from active cell material 106, it should be appreciated that device 100 and/or smart cell module 104 can thereby eliminate galvanic contact of one or more components of device 100 with one or more devices that are external to device 100 (e.g., another battery device and/or battery cell device in a battery pack including device 100). By eliminating such galvanic contact, device 100 and/or smart cell module 104 can thereby provide enhanced safety when compared to existing battery device and/or battery cell device technologies (e.g., when compared to prior art battery device and/or battery cell device technologies). Additionally, or alternatively, by eliminating such galvanic contact, device 100 and/or smart cell module 104 can thereby eliminate hardware such as, for instance, cables, which are used in existing battery pack and/or BMS technologies (e.g., BMS wires coupled to one or more battery devices and/or battery cell devices in a battery pack).

Processor 302 can include one or more types of processors and/or electronic circuitry (e.g., a classical processor, a quantum processor, etc.) that can implement one or more computer and/or machine readable, writable, and/or executable components and/or instructions that can be stored on memory 304. For example, processor 302 can perform various operations that can be specified by such computer and/or machine-readable, writable, and/or executable components and/or instructions including, but not limited to, logic, control, input/output (I/O), arithmetic, and/or the like. Processor 302 can include one or more CPUs, multi-core processors, microprocessors, dual microprocessors, microcontrollers, Systems on a Chip (SOCs), array processors, vector processors, quantum processors, and/or other types of processor. Such examples of processor 302 can be employed to implement any embodiments of the present disclosure.

In the example embodiment illustrated in FIG. 3, processor 302 can include a CPU such as, for example, a microprocessor. In some embodiments, processor 302 can include and/or employ one or more machine learning (ML) and/or artificial intelligence (AI) models to learn, for instance, one or more operating conditions and/or cause and effect conditions corresponding to device 100 and/or an external device coupled to device 100. In these embodiments, based on learning such one or more operating conditions and/or cause and effect conditions, processor 302 can further employ the one or more ML and/or AI models to perform one or more tasks including, but not limited to, making a prediction, making an estimation (e.g., cell capacity (e.g., electric energy) of active cell material 106), classifying data, implementing one or more monitoring and/or control operations of device 100 and/or smart cell module 104, and/or another task.

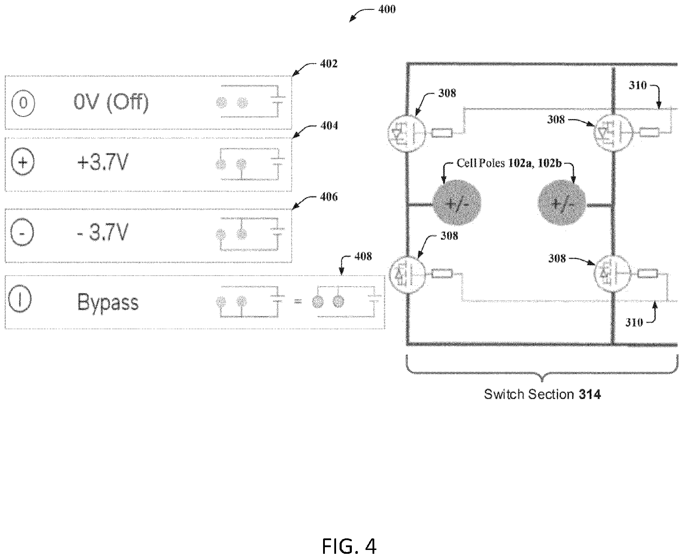

Memory 304 can store one or more computer and/or machine-readable, writable, and/or executable components and/or instructions that, when executed by processor 302 (e.g., a classical processor, a quantum processor, etc.), can facilitate performance of operations defined by the executable component(s) and/or instruction(s). For example, memory 304 can store computer and/or machine-readable, writable, and/or executable components and/or instructions that, when executed by processor 302, can facilitate execution of the various functions described herein relating to device 100 and/or smart cell module 104 as described herein with or without reference to the various figures of the present disclosure. For instance, memory 304 can store computer and/or machine-readable, writable, and/or executable components and/or instructions that, when executed by processor 302, can facilitate one or more of such parameter monitoring tasks described above with reference to FIG. 1 and/or to facilitate logging of monitoring data collected by one or more sensors 306. In another example, memory 304 can store computer and/or machine -readable, writable, and/or executable components and/or instructions that, when executed by processor 302, can facilitate operation of one or more switches 308 to configure device 100 to operate in one or more operation modes 400 described below with reference to FIG. 4.

In an embodiment, memory 304 can store computer and/or machine-readable, writable, and/or executable components and/or instructions such as, for instance, a monitoring component that, when executed by processor 302, can employ one or more sensors 306 of smart cell module 104 in device 100 to collect parameter data corresponding to device 100 and/or one or more components thereof. In this embodiment, such a monitoring component can further store and/or log (e.g., via processor 302) the parameter data in memory 304.

In another embodiment, memory 304 can store computer and/or machine-readable, writable, and/or executable components and/or instructions such as, for instance, a ML component that, when executed by processor 302, can facilitate operation of one or more switches 308 (e.g., based on parameter data collected from device 100) to configure device 100 to operate in one or more operation modes 400 described below with reference to FIG. 4. In this embodiment, such a ML component can learn to identify certain parameter data collected from device 100 that can be indicative of certain events and/or conditions associated with device 100, a battery pack including device 100, and/or an electronic system (e.g., an electric driveline of an EV or HEV) including device 100. For example, the ML component can learn (e.g., by being trained using one or more supervised leaning techniques, unsupervised learning techniques, etc.) to identify certain parameter data that can be indicative of, for instance: a high or low state of charge (SoC) in device 100; a crash of a vehicle (e.g., an EV or HEV) including device 100; a high or low temperature of one or more components of device 100; a high or low pressure in device 100, and/or another event and/or condition. In this example, based on identifying such parameter data that can be indicative of one or more such events and/or conditions defined above, the ML component can then configure device 100 (e.g., via processor 302, one or more switches 308, etc.) in a certain operation mode as described above (e.g., in an off mode and/or a bypass mode based on detecting a crash of a vehicle including device 100). In some embodiments, such a ML component described above can include a ML model based on AI including, but not limited to, a shallow or deep neural network model, a support vector machine (SVM) model, a classifier, a decision tree classifier, a regression model, and/or any supervised or unsupervised ML model that can perform the operations of the ML component described above.

Memory 304 can include volatile memory (e.g., random access memory (RAM), static RAM (SRAM), dynamic RAM (DRAM), etc.) and/or non-volatile memory (e.g., read only memory (ROM), programmable ROM (PROM), electrically programmable ROM (EPROM), electrically erasable programmable ROM (EEPROM), etc.) that can employ one or more memory architectures. Such examples of memory 304 can be employed to implement any embodiments of the present disclosure.

One or more sensors 306 can include, for instance, a temperature sensor, a pressure sensor, a chemical sensor, an accelerometer, and/or another sensor that can measure one or more parameters of device 100 and/or active cell material 106. As illustrated in the example embodiment depicted in FIG. 3, sensors 306 can provide sensing data to processor 302 in the form of electric current (e.g., denoted as Iₛₑₙₛₑ in FIG. 3) and/or electric voltage (e.g., denoted as Vₛₑₙₛₑ in FIG. 3). Processor 302 can facilitate the recording of such sensing data in, for instance, a text file and/or a log that can be stored on memory 304. In some embodiments, smart cell module 104 can share such sensing data with a device that can be external to device 100 (e.g., a computing resource in a cloud computing environment). Based on such sensing data, processor 302 can operate (e.g., open or close) one or more switches 308 to implement one or more operation modes of device 100.

One or more switches 308 can include MOSFET switches. One or more switches 308 can be configured in smart cell module 104 such that actuation of such one or more switches 308 (e.g., via processor 302) can implement one or more operation modes of device 100.

Smart cell module 104, processor 302, memory 304, one or more sensors 306, and/or one or more switches 308 can be coupled to one another via a bus 310 to perform functions of device 100, smart cell module 104, and/or any components coupled therewith. Bus 310 can include one or more memory bus, memory controller, peripheral bus, external bus, local bus, a quantum bus, and/or another type of bus that can employ various bus architectures. Such examples of bus 310 can be employed to implement any embodiments of the present disclosure.

FIG. 4 illustrates example, non-limiting operation modes 400 that can facilitate an intelligent battery cell with integrated monitoring and switching in accordance with one or more embodiments described herein. Repetitive description of like elements and/or processes employed in respective embodiments is omitted for sake of brevity.

Device 100 can operate in one or more operation modes 400. Operation modes 400 can include an off mode 402 (denoted as "0V (Off)" in FIG. 4), a positive mode 404 (denoted as "+3.7V" in FIG. 4), a negative mode 406 (denoted as "-3.7V" in FIG. 4, also referred to as a reverse mode), and/or a bypass mode 408 (denoted as "Bypass" in FIG. 4). In some embodiments, implementation of one or more operation modes 400 defined above can enable device 100 to control (e.g., via smart cell module 104) its contribution (e.g., electric voltage contribution) to a battery pack including device100. To implement such one or more operation modes 400 defined above, processor 302 of smart cell module 104 can operate (e.g., open, close, turn on, turn off, engage, disengage, etc.) one or more switches 308 to control cell poles 102a, 102b (e.g., to control the electric energy (e.g., electric current, electric voltage, etc.) present at and/or across cell poles 102a, 102b).

Bypass mode 408 can include a default mode of device 100 and thus, device 100 and/or smart cell module 104 can be in a passive state until "armed" (e.g., until set into off mode 402, positive mode 404, or negative mode 406). In bypass mode 408, there is no voltage on cell poles 102a, 102b.

It should be appreciated that device 100 can be configured (e.g., set) to operate in bypass mode 408 to mitigate risk of injury and/or damage to a person and/or property. For example, during installation of device 100 in an electronic system, device 100 can be configured (e.g., by operating one or more switches 308 via processor 302) to operate in bypass mode 408 to mitigate risk of injury and/or damage to a person (e.g., a technician performing the installation) and/or property (e.g., automated equipment performing the installation and/or property within a certain proximity of the electronic system). In another example, during installation of a battery pack including one or more devices 100 in an electronic system (e.g., an electric driveline of an EV or HEV), each device 100 in the battery pack can be individually configured (e.g., by operating one or more switches 308 via processor 302) to operate in bypass mode 408 to mitigate risk of injury and/or damage to a person (e.g., a technician performing the installation) and/or property (e.g., automated equipment performing the installation and/or property within a certain proximity of the electronic system).

It should also be appreciated that in operation, each device 100 in a battery pack can be individually configured to operate in off mode 402, positive mode 404, negative mode 406, or bypass mode 408 to facilitate a desired yield of electric energy (e.g., electric current, electric voltage, etc.) from each device 100 and/or from the battery pack. For example, one or more devices 100 in a battery pack can be individually configured (e.g., by operating one or more switches 308 via processor 302) to operate in bypass mode 408 to facilitate a desired yield of electric energy (e.g., electric current, electric voltage, etc.) from one or more other battery devices and/or battery cell devices in the battery pack. In some embodiments, such one or more other battery devices and/or battery cell devices can also include one or more devices 100 that can be individually configured (e.g., by operating one or more switches 308 via processor 302) to operate in one of the operation modes 400 defined above (e.g., off mode 402, positive mode 404, negative mode 406, and/or bypass mode 408).

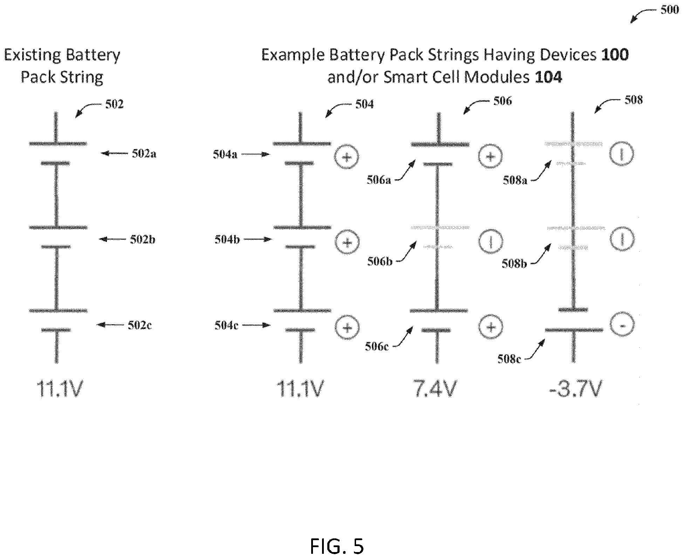

FIG. 5 illustrates example, non-limiting electrical diagrams 500 that can facilitate an intelligent battery cell with integrated monitoring and switching in accordance with one or more embodiments described herein. Repetitive description of like elements and/or processes employed in respective embodiments is omitted for sake of brevity.

String 502 is an electrical diagram representing an existing battery pack string (e.g., a battery pack string currently used in prior art technologies) that couples multiple battery devices and/or battery cell devices 502a, 502b, 502c in series to yield 11.1V of electric voltage. Battery devices and/or battery cell devices 502a, 502b, 502c include battery devices and/or battery cell devices that do not include device 100 and/or smart cell module 104.

String 504 is an electrical diagram representing an example, non-limiting battery pack string that can include multiple battery devices and/or battery cell devices 504a, 504b, 504c that can be coupled in series to yield, for example, 11.1V of electric voltage. Battery devices and/or battery cell devices 504a, 504b, 504c can each include the same structure and/or functionality as that of device 100 and/or smart cell module 104. As illustrated in FIG. 5, to yield 11.1V of electric voltage, for example, battery devices and/or battery cell devices 504a, 504b, 504c of string 504 can all be configured (e.g., as described above with reference to FIG. 4) to operate in positive mode 404.

String 506 is an electrical diagram representing an example, non-limiting battery pack string that can include multiple battery devices and/or battery cell devices 506a, 506b, 506c that can be coupled in series to yield, for example, 7.4V of electric voltage. Battery devices and/or battery cell devices 506a, 506b, 506c can each include the same structure and/or functionality as that of device 100 and/or smart cell module 104. As illustrated in FIG. 5, to yield 7.4V of electric voltage, for example, battery device and/or battery cell device 506b of string 506 can be configured (e.g., as described above with reference to FIG. 4) to operate in bypass mode 408 while battery devices and/or battery cell devices 506a and 506c can be configured to operate in positive mode 404.

String 508 is an electrical diagram representing an example, non-limiting battery pack string that can include multiple battery devices and/or battery cell devices 508a, 508b, 508c that can be coupled in series to yield, for example, -3.7V of electric voltage. Battery devices and/or battery cell devices 508a, 508b, 508c can each include the same structure and/or functionality as that of device 100 and/or smart cell module 104. As illustrated in FIG. 5, to yield -3.7V of electric voltage, for example, battery devices and/or battery cell devices 508a and 508b of string 508 can be configured (e.g., as described above with reference to FIG. 4) to operate in bypass mode 408 while battery device and/or battery cell device 508c can be configured to operate in negative mode 406.

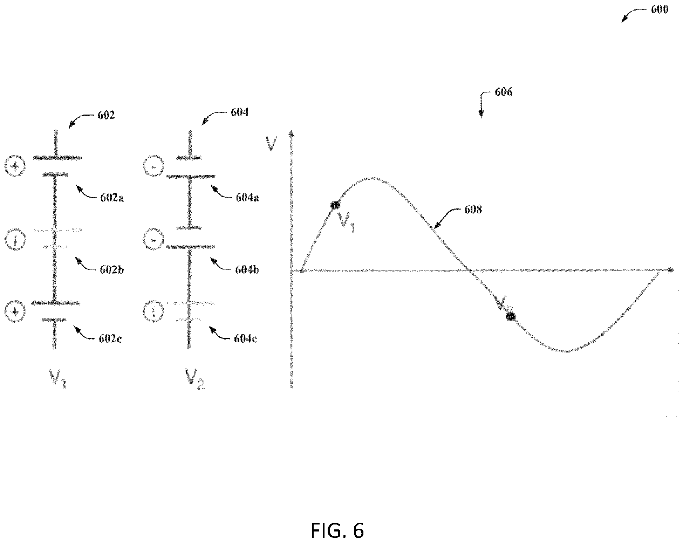

FIG. 6 illustrates an example, non-limiting diagram 600 that can facilitate an intelligent battery cell with integrated monitoring and switches in accordance with one or more embodiments described herein. Repetitive description of like elements and/or processes employed in respective embodiments is omitted for sake of brevity.

Diagram 600 can include strings 602, 604. Diagram 600 can further include a plot 606 depicting a voltage curve 608 corresponding to strings 602, 604.

String 602 is an electrical diagram representing an example, non-limiting battery pack string that can include multiple battery devices and/or battery cell devices 602a, 602b, 602c that can be coupled in series to yield, for example, 7.4V of electric voltage (denoted as V1 in FIG. 6). Battery devices and/or battery cell devices 602a, 602b, 602c can each include the same structure and/or functionality as that of device 100 and/or smart cell module 104. As illustrated in FIG. 6, to yield 7.4V of electric voltage (V1), for example, battery device and/or battery cell device 602b of string 602 can be configured (e.g., as described above with reference to FIG. 4) to operate in bypass mode 408 while battery devices and/or battery cell devices 602a and 602c can be configured to operate in positive mode 404.

String 604 is an electrical diagram representing an example, non-limiting battery pack string that can include multiple battery devices and/or battery cell devices 604a, 604b, 604c that can be coupled in series to yield, for example, -7.4V of electric voltage (denoted as V2 in FIG. 6). Battery devices and/or battery cell devices 604a, 604b, 604c can each include the same structure and/or functionality as that of device 100 and/or smart cell module 104. As illustrated in FIG. 6, to yield -7.4V of electric voltage (V2), for example, battery devices and/or battery cell devices 604a and 604b of string 604 can be configured (e.g., as described above with reference to FIG. 4) to operate in negative mode 406 while battery device and/or battery cell device 604c can be configured to operate in bypass mode 408.

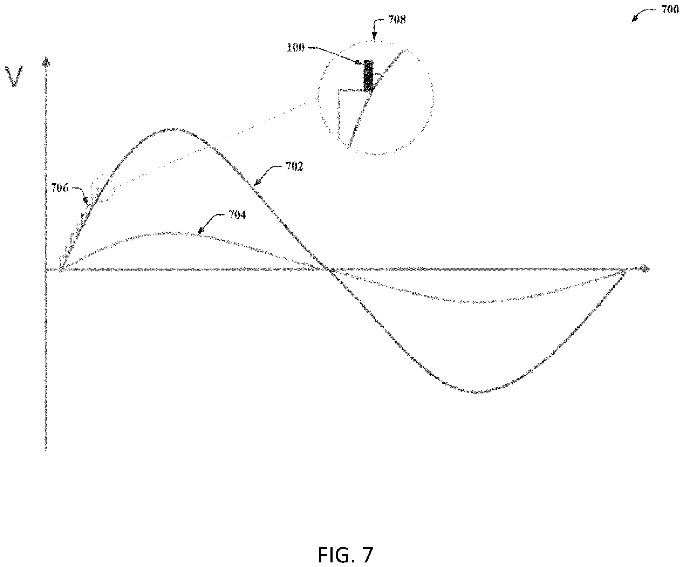

Voltage curve 608 depicted in plot 606 can be generated based on V1 (7.4V) and V2 (-7.4V), where V1 and V2 can be yielded by strings 602, 604, respectively, as described above. The curve shape of voltage curve 608 can be divided into multiple steps (e.g., steps 706 described below with reference to FIG. 7). For instance, the curve shape of voltage curve 608 can be divided into 2*96 steps (192 steps), which can reduce noise, vibration, and harshness (NVH) and electromotive force (EMF). In some embodiments, the main voltage (e.g., main voltage of a battery pack including one or more devices 100) can be (3)^{1/2∗}370V = 640V, which is approximately the same as an 800V battery.

FIG. 7 illustrates an example, non-limiting plot 700 that can facilitate an intelligent battery cell with integrated monitoring and switching in accordance with one or more embodiments described herein. Repetitive description of like elements and/or processes employed in respective embodiments is omitted for sake of brevity.

Plot 700 can include voltage curves 702, 704 that can each represent electric voltage of a battery pack string including one or more devices 100 and/or smart cell modules 104. Voltage curves 702, 704 can each be generated using multiple steps 706 (e.g., as depicted on voltage curve 702 in FIG. 7). Each of steps 706 can represent the electric voltage (e.g., positive or negative) that can be yielded by a single device 100 in a battery pack string, for example, as illustrated by the visual representation of such a single device 100 in inset 708 depicted in FIG. 7. Voltage curve 704 can include a voltage curve that can be generated by applying pulse width modulation (PWM) to the last cell of a battery pack (e.g., to the last device 100 in a battery pack string). In some embodiments, applying PWM as described above can be useful when a voltage curve at low voltage is requested. In some embodiments, applying PWM as described above can also be useful in embodiments where a single smart cell module 104 is used to control multiple cells in a battery pack (e.g., multiple active cell material 106 in a battery pack).

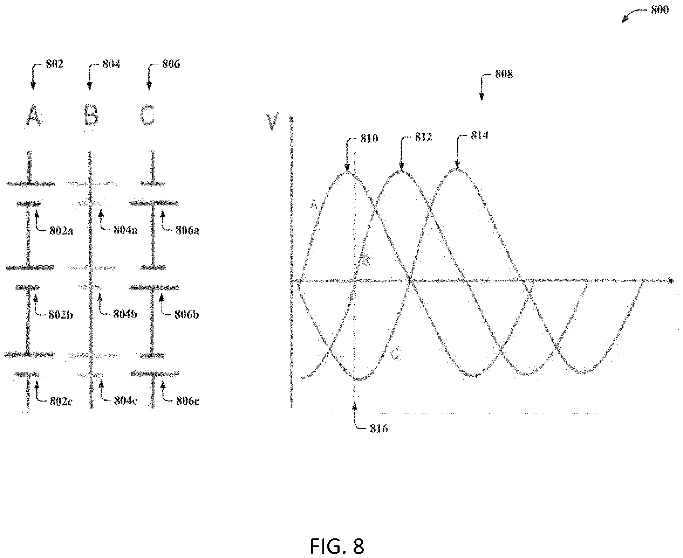

FIG. 8 illustrates an example, non-limiting diagram 800 that can facilitate an intelligent battery cell with integrated monitoring and switching in accordance with one or more embodiments described herein. Repetitive description of like elements and/or processes employed in respective embodiments is omitted for sake of brevity.

Diagram 800 can include strings 802, 804, 806. Diagram 800 can further include a plot 808 depicting voltage curves 810, 812, 814 corresponding to strings 802, 804, 806, respectively.

String 802 is an electrical diagram representing an example, non-limiting battery pack string that can include multiple battery devices and/or battery cell devices 802a, 802b, 802c that can be coupled in series to yield, for example, 11.1V of electric voltage. Battery devices and/or battery cell devices 802a, 802b, 802c can each include the same structure and/or functionality as that of device 100 and/or smart cell module 104. As illustrated in FIG. 8, to yield 11.1V of electric voltage, for example, all battery devices and/or battery cell devices 802a, 802b, 802c of string 802 can be configured (e.g., as described above with reference to FIG. 4) to operate in positive mode 404.

String 804 is an electrical diagram representing an example, non-limiting battery pack string that can include multiple battery devices and/or battery cell devices 804a, 804b, 804c that can be coupled in series to yield, for example, 0.0V of electric voltage. Battery devices and/or battery cell devices 804a, 804b, 804c can each include the same structure and/or functionality as that of device 100 and/or smart cell module 104. As illustrated in FIG. 8, to yield 0.0V of electric voltage, for example, all battery devices and/or battery cell devices 804a, 804b, 804c of string 804 can be configured (e.g., as described above with reference to FIG. 4) to operate in bypass mode 408.

String 806 is an electrical diagram representing an example, non-limiting battery pack string that can include multiple battery devices and/or battery cell devices 806a, 806b, 806c that can be coupled in series to yield, for example, -11. 1V of electric voltage. Battery devices and/or battery cell devices 806a, 806b, 806c can each include the same structure and/or functionality as that of device 100 and/or smart cell module 104. As illustrated in FIG. 8, to yield -11. 1V of electric voltage, for example, all battery devices and/or battery cell devices 806a, 806b, 806c of string 806 can be configured (e.g., as described above with reference to FIG. 4) to operate in negative mode 406.

Voltage curves 810, 812, 814 can each include an example, non-limiting alternative embodiment of voltage curve 608, 702, and/or 704, where voltage curves 810, 812, 814 can be generated based on electric voltages that can be yielded by strings 802, 804, 806, respectively. For example, voltage curves 810, 812, 814 can be generated using steps 706 as described above with reference to FIG. 7, where each step 706 of each voltage curve 810, 812, 814 can represent an electric voltage yielded by a single device 100 in each of strings 802, 804, 806.

As illustrated by voltage curves 810, 812, 814 depicted in FIG. 8, strings 802, 804, 806 can yield respective electric voltages that, when combined as shown in plot 808, can provide a three phase (3-phase) current source (e.g., an AC source) that can be used to drive, for example, an electrical motor, an AC-charger, and/or another electronic device. For instance, strings 802, 804, 806 can yield respective electric voltages that, when combined as shown in plot 808, can function as a multilevel inverter having a cascading H-bridge design (e.g., an H-bridge design as described above with reference to FIG. 3 that can be implemented using one or more switches 308 of switch section 314). In some embodiments, to provide such a 3-phase current source described above, plot 808 and/or voltage curves 810, 812, 814 can be "frozen in time" at a time 816 depicted on plot 808 in FIG. 8. In these embodiments, at time 816, strings 802, 804, 806 can respectively yield, for example, 11.1V, 0.0V, -11.1V of electric voltage, which can produce the 3-phase current source described above. In some embodiments, switch losses associated with each of strings 802, 804, 806 (e.g., losses associated with one or more switches 308 described above with reference to FIG. 3) can be linear to the frequency of each voltage curve 810, 812, 814.

It should be appreciated that the implementation of strings 802, 804, 806 and/or voltage curves 810, 812, 814 in an electronic system to provide the 3-phase current source (e.g., an AC source) described above can eliminate the use of an inverter in such an electronic system. For example, it should be appreciated that the implementation of strings 802, 804, 806 in a DC battery pack of an electric driveline in an EV or HEV to provide the 3-phase current source (e.g., an AC source) described above can eliminate the use of an inverter in such an EV to change the DC provided by the battery pack to AC (e.g., to change the DC provided by strings 802, 804, 806 to AC).

FIG. 9 illustrates example, non-limiting electronic systems 900 that can facilitate an intelligent battery cell with integrated monitoring and switching in accordance with one or more embodiments described herein. Repetitive description of like elements and/or processes employed in respective embodiments is omitted for sake of brevity.

Electronic systems 900 can include example, non-limiting electronic systems 902, 904, 906 illustrated in FIG. 9. Each of electronic systems 902, 904, 906 can include an example, non-limiting embodiment of the present disclosure that can include one or more other embodiments of the present disclosure described herein (e.g., device 100, device 200, etc.). In some embodiments, each of electronic systems 902, 904, 906 can include an electric driveline that can be implemented in an EV or HEV to, for example, provide electric power (e.g., AC or DC) directly (e.g., without the use of, for instance, an inverter) to one or more electronic components in the EV and/or to enable a battery pack of the electric driveline to be charged using an AC or DC charger.

Electronic system 902 can include a battery pack 908. Battery pack 908 can include the same structure and/or functionality as that of the battery pack described above with reference to FIGS. 1-8 (e.g., a battery pack including multiple devices 100 and/or devices 200). Battery pack 908 of electronic system 902 can include multiple devices 100 (e.g., forty-two devices 100) that be coupled to one another in series to form multiple strings 910 (e.g., three strings 910). Strings 910 of electronic system 902 can be coupled to one another in parallel as illustrated in FIG. 9. For clarity, only one device 100 and only one string 910 are identified in electronic system 902 depicted in FIG. 9. Each device 100 of each string 910 in battery pack 908 of electronic system 902 can be individually configured to operate in a certain operation mode 400 (e.g., as described above with reference to FIG. 4) to yield a desired electric voltage (e.g., a certain positive or negative electric voltage value). For example, each device 100 of each string 910 in battery pack 908 of electronic system 902 can be individually configured to operate in off mode 402, positive mode 404, negative mode 406, or bypass mode 408 such that battery pack 908 can provide AC electric power to one or more motors 912a, 912b (respectively denoted as "M" and "M*" in FIG. 9).

Electronic system 904 can include battery pack 908. Battery pack 908 of electronic system 904 can include multiple devices 100 (e.g., forty-two devices 100) that be coupled to one another in series to form multiple strings 910 (e.g., three strings 910). Strings 910 of electronic system 904 can be coupled to one another in parallel as illustrated in FIG. 9. For clarity, only one device 100 and only one string 910 are identified in electronic system 904 depicted in FIG. 9. Each device 100 of each string 910 in battery pack 908 of electronic system 904 can be individually configured to operate in a certain operation mode 400 (e.g., as described above with reference to FIG. 4) to yield a desired electric voltage (e.g., a certain positive or negative electric voltage value). For example, each device 100 of each string 910 in battery pack 908 of electronic system 904 can be individually configured to operate in off mode 402, positive mode 404, negative mode 406, or bypass mode 408 such that battery pack 908 can be coupled to an AC charger 914 (denoted as "AC Chrg" in FIG. 9) to enable AC charging of battery pack 908 of electronic system 904 (e.g., AC charging to approximately 400V as illustrated in FIG. 9). In this example, AC charger 914 can include an AC charger including, but not limited to, a single-phase AC charger, a 3-phase AC charger, and/or another type of AC charger.

Electronic system 906 can include battery pack 908. Battery pack 908 of electronic system 906 can include multiple devices 100 (e.g., forty-two devices 100) that be coupled to one another in series to form multiple strings 910 (e.g., three strings 910). Strings 910 of electronic system 906 can be coupled to one another in series as illustrated in FIG. 9. For clarity, only one device 100 and only one string 910 are identified in electronic system 906 depicted in FIG. 9. Each device 100 of each string 910 in battery pack 908 of electronic system 906 can be individually configured to operate in a certain operation mode 400 (e.g., as described above with reference to FIG. 4) to yield a desired electric voltage (e.g., a certain positive or negative electric voltage value). For example, each device 100 of each string 910 in battery pack 908 of electronic system 906 can be individually configured to operate in off mode 402, positive mode 404, negative mode 406, or bypass mode 408 such that battery pack 908 can be coupled to a DC charger (not illustrated in FIG. 9) to enable DC charging of battery pack 908 of electronic system 906 (e.g., DC charging to approximately 1200V as illustrated in FIG. 9).

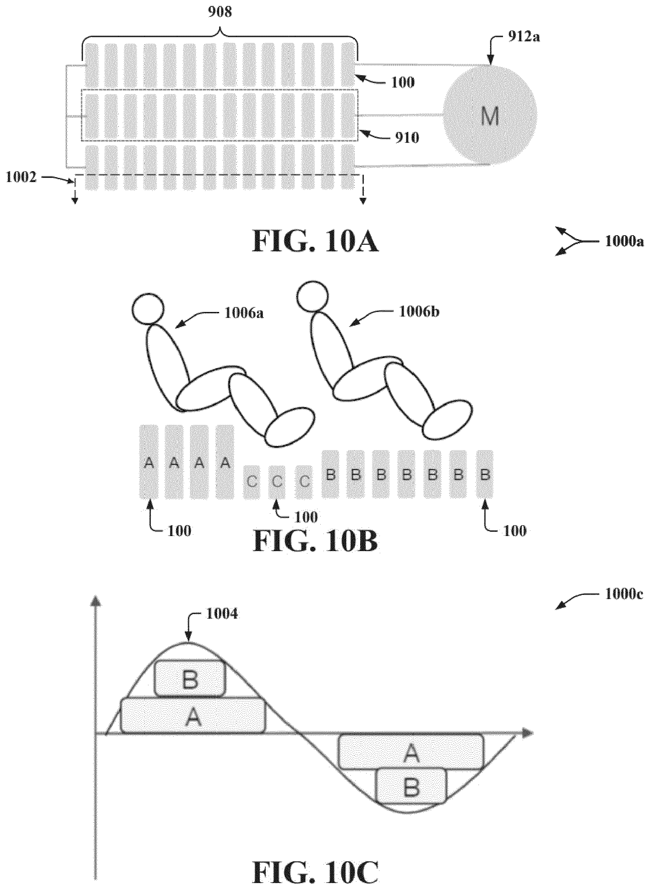

FIG. 10A illustrates a top view of an example, non-limiting electronic system 1000a that can facilitate an intelligent battery cell with integrated monitoring and switching in accordance with one or more embodiments described herein. FIG. 10B illustrates a cross-sectional side view of one or more components of electronic system 1000a as viewed along a plane defined by line 1002. FIG. 10C illustrates an example, non-limiting plot 1000c corresponding to electronic system 1000a. Repetitive description of like elements and/or processes employed in respective embodiments is omitted for sake of brevity.

Electronic system 1000a can include an example, non-limiting alternative embodiment of electronic system 902 described above with reference to FIG. 9. In some embodiments, electronic system 1000a can include an electric driveline that can be implemented in an EV or HEV to, for example, provide electric power (e.g., AC or DC) directly (e.g., without the use of, for instance, an inverter) to one or more electronic components in the EV (e.g., motor 912a) and/or to enable a battery pack of the electric driveline to be charged using an AC or DC charger.

Electronic system 1000a can include battery pack 908. Battery pack 908 of electronic system 1000a can include multiple devices 100 (e.g., forty-two devices 100) that be coupled to one another in series to form multiple strings 910 (e.g., three strings 910). Strings 910 of electronic system 1000a can be coupled to one another in parallel as illustrated in FIG. 10A. For clarity, only one device 100 and only one string 910 are identified in electronic system 1000a depicted in FIG. 10A. Each device 100 of each string 910 in battery pack 908 of electronic system 1000a can be individually configured to operate in a certain operation mode 400 (e.g., as described above with reference to FIG. 4) to yield a desired electric voltage (e.g., a certain positive or negative electric voltage value). For example, each device 100 of each string 910 in battery pack 908 of electronic system 1000a can be individually configured to operate in off mode 402, positive mode 404, negative mode 406, or bypass mode 408 such that battery pack 908 can provide AC electric power to motor 912a (denoted as "M" in FIG. 10A). In another example, each device 100 of each string 910 in battery pack 908 of electronic system 1000a can be individually configured to operate in off mode 402, positive mode 404, negative mode 406, or bypass mode 408 such that battery pack 908 can provide (e.g., in parallel, simultaneously) AC electric power to motor 912a and one or more other motors (not illustrated in FIG. 10A).

Each device 100 in battery pack 908 of electronic system 1000a can be controlled individually (e.g., via smart cell module 104 as described above with reference to FIGS. 1-9). Usage of each device 100 can be controlled (e.g., via smart cell module 104) with a corresponding duty cycle defined for each device 100. To facilitate individual control of each device 100 in battery pack 908, in some embodiments, battery pack 908 can also be coupled to, for instance, a control unit (e.g., a vehicle control unit (VCU), not illustrated in FIGS. 10A, 10B, or 10C) that can control the total electric power output (e.g., electric voltage, electric current, etc.) of battery pack 908 by individually controlling electric power output of each device 100 in battery pack 908. Such a control unit (e.g., a VCU) can individually control the electric power output of each device 100 in battery pack 908 by configuring each device 100 (e.g., via smart cell module 104 in each device 100) to operate in off mode 402, positive mode 404, negative mode 406, or bypass mode 408 for a certain duration. By configuring each device 100 in battery pack 908 to operate in off mode 402, positive mode 404, negative mode 406, or bypass mode 408 for a certain duration, such a control unit (e.g., a VCU) can thereby define a certain duty cycle for each device 100 in battery pack 908. In some embodiments, such a control unit (e.g., a VCU) can employ a scheduler component (not illustrated in the figures) to define the duration that each device 100 in battery pack 908 will remain in off mode 402, positive mode 404, negative mode 406, or bypass mode 408. By individually implementing the duty cycle of each device 100 in battery pack 908, such a control unit (e.g., a VCU) can individually "switch on" one or more certain devices 100 in battery pack 908 and individually "switch off' one or more other devices 100 in battery pack 908 to yield a desired electrical output from battery pack 908.

It should be appreciated that, in some embodiments, electronic system 1000a does not include the above described control unit. In these embodiments, each device 100 in battery pack 908 can control its own electric power output (e.g., as described above with reference to FIGS. 1-9), and therefore, all devices 100 in battery pack 908 can collectively control the electric power output (e.g., electric voltage, electric current, etc.) of battery pack 908. In these embodiments, each device 100 in battery pack 908 can also communicate periodically (e.g., every second) with all other devices 100 in battery pack 908 to facilitate, if needed, adjustment of the electric power output of each device 100 to, for instance, maintain a certain electric power output of battery pack 908. For example, each device 100 can communicate with all other devices 100 in battery pack 908 (e.g., wirelessly via smart cell module 104, network 112, etc.) to, for instance: determine each other's SoC status; exchange each other's assigned duty cycles; and/or exchange revised duty cycles of one or more certain devices 100 that can be modified based on, for instance, a change in the SoC status of one or more other devices 100 in battery pack 908.

In some embodiments, battery pack 908 can include devices 100 having different chemistries and/or different sized devices 100 (denoted as "A," "B," and "C" in FIG. 10B), where the size of each device 100 can be indicative of its electrical capacity (e.g., electric voltage, electric current, electric power, etc.). For example, a relatively large device 100 such as, for instance, device 100 denoted in FIG. 10B as "A" can include a relatively larger electrical capacity than that of devices 100 denoted in FIG. 10B as "B" and "C." In embodiments where battery pack 908 is also coupled to the control unit described above (e.g., a VCU), such a control unit can define (e.g., as described above) a duty cycle for each device 100 that is based on the device's electrical capacity. For example, such a control unit can define a duty cycle for a device 100 denoted in FIG. 10B as "A" that is longer in duration than that of the duty cycles for devices 100 denoted in FIG. 10B as "B" and "C," where device 100 denoted in FIG. 10B as "A" includes a relatively larger electrical capacity than that of devices 100 denoted in FIG. 10B as "B" and "C." For instance, as illustrated by voltage curve 1004 of plot 1000c depicted in FIG. 10C, such a control unit can define a duty cycle for a device 100 denoted in FIG. 10C as "A" that is longer in duration than that of a duty cycle for device 100 denoted in FIG. 10C as "B."

As each device 100 in battery pack 908 can be individually controlled as described above, various parameters of battery pack 908 (e.g., dimensions, weight, etc.) can be optimized for a certain packaging space. For example, various parameters of battery pack 908 (e.g., dimensions, weight, etc.) can be optimized (e.g., using a bin packing algorithm) for a certain packaging space based on one or more parameters (e.g., dimensions, weight, etc.) of each device 100 in battery pack 908. For instance, various parameters of battery pack 908 (e.g., dimensions, weight, etc.) can be optimized (e.g., using a bin packing algorithm) based on one or more parameters (e.g., dimensions, weight, etc.) of each device 100 in battery pack 908 such that battery pack 908 can occupy (e.g., fully or partially) a certain packaging space in, for example, one or more components of an EV (e.g., in a frame, chassis, body, and/or seat of an EV as illustrated in FIG. 10B, where entities 1006a, 1006b represent occupants (e.g., humans) of such an EV).

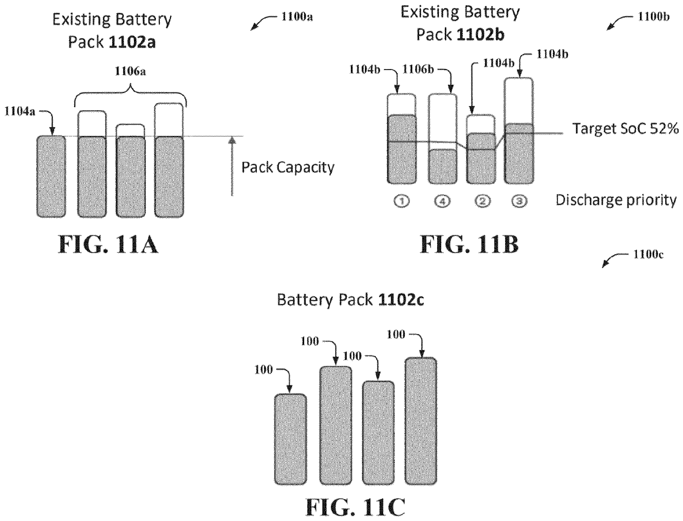

FIGS. 11A and 11B illustrate example, non-limiting existing devices 1100a, 1100b (e.g., prior art devices). FIG. 11C illustrates an example, non-limiting device 1100c that can facilitate an intelligent battery cell with integrated monitoring and switching in accordance with one or more embodiments described herein. Repetitive description of like elements and/or processes employed in respective embodiments is omitted for sake of brevity.

Device 1100a includes an existing battery pack 1102a (e.g., a battery pack currently used in prior art technologies) having battery cells 1104a, 1106a. Device 1100a illustrates how the electrical capacity (denoted as "pack capacity" and represented by the dark gray shading in FIG. 11A) of existing battery pack 1102a is limited by battery cell 1104a which has the lowest electrical capacity relative to that of all other battery cells 1106a in existing battery pack 1102a.

Device 1100b includes an existing battery pack 1102b (e.g., a battery pack currently used in prior art technologies) having battery cells 1104b, 1106b. Device 1100b illustrates how the electric energy (e.g., electric voltage, electric current, etc.) of each battery cell 1104b, 1106b in existing battery pack 1102b is drained (e.g., discharged) according to a discharge priority schedule (denoted as "discharge priority" in FIG. 11B) and/or a target SoC of, for instance, 52% as illustrated in FIG. 11B. In operation, each battery cell 1104b, 1106b in existing battery pack 1102b can be drained to the target SoC (e.g., drained to an SoC of 52% as illustrated in FIG. 11B). However, when one or more battery cells 1104b, 1106b (e.g., battery cell 1106b as illustrated in FIG. 11B) are drained (e.g., discharged) to a level that is lower than the target SoC (e.g., lower than a SoC of 52%), existing battery pack 1102b stops functioning (e.g., stops discharging electric voltage, electric current, etc.).

Device 1100c includes a battery pack 1102c having multiple devices 100. Battery pack 1102c can include the same structure and/or functionality as that of battery pack 908 described above with reference to FIGS. 9, 10A, 10B, and 10C. As each device 100 in battery pack 1102c can be individually controlled (e.g., as described above with reference to FIGS. 10A, 10B, and 10C), device 1100c illustrates how the electric energy (e.g., electric voltage, electric current, etc.) of each device 100 in battery pack 1102c can be used (e.g., discharged) to its full extent. It should be appreciated that such use of all electric energy available in each device 100 in battery pack 1102c eliminates the use of balancing techniques (e.g., load balancing techniques) employed by existing battery packs (e.g., existing battery pack 1102a and/or 1102b described above and illustrated in FIGS. 11A and 11B, respectively).

During operation of battery pack 1102c, the duty cycle defined for each device 100 in battery pack 1102c (e.g., as described above with reference to FIGS. 10A, 10B, and 10C) can dictate how much electric energy (e.g., electric voltage, electric current, etc.) of each device 100 is used (e.g., discharged). Therefore, the electric energy (e.g., electric voltage, electric current, etc.) of each device 100 in battery pack 1102c can be used (e.g., discharged) to its full extent (e.g., all or nearly all electric energy of each device 100 can be used). Consequently, it should be appreciated that the variation in electrical capacity of each device 100 in battery pack 1102c illustrated in FIG. 11C will not be a limit to the electrical capacity of battery pack 1102c.

In some embodiments, a certain device 100 in battery pack 1102c can determine (e.g., via one or more sensors 306 of smart cell module 104) that its electric energy is at or approaching a defined low level (e.g., a target SoC percentage) and can further communicate such information to a control unit that can be coupled to battery pack 1102c (e.g., the control unit described above with reference to FIGS. 10A, 10B, and 10C). In these embodiments, this certain device 100 (e.g., via smart cell module 104) and/or the control unit can modify the duty cycle corresponding to such a certain device 100. For example, this certain device 100 (e.g., via smart cell module 104) and/or the control unit can reduce the duration of the duty cycle corresponding to this certain device 100 such that less electric energy is discharged from this certain device 100.

Battery pack 1102c can be discharged at a discharge amount (e.g., discharge rate, discharge voltage, discharge current, etc.) that can be determined based on a target SoC percentage and/or a cell priority stack corresponding to devices 100 in battery pack 1102c. Additionally, or alternatively, each device 100 in battery pack 1102c can include a modular component that can function and/or be controlled independent of all other devices 100 in battery pack 1102c. Therefore, for example, in operation, when one or more devices 100 in battery pack 1102c are approaching the SoC percentage or are drained below the SoC percentage, such one or more devices 100 can be reconfigured (e.g., via smart cell module 104 and/or the control unit described above) to operate in bypass mode 408 and/or can be reprioritized to a lower discharge priority level. In this example, one or more other devices 100 in battery pack 1102c can then be configured or reconfigured to operate in a certain operation mode 400 (e.g., off mode 402, positive mode 404, negative mode 406, or bypass mode 408) that can enable battery pack 1102c to continue operating, unaffected, at the same discharge amount (e.g., discharge rate, discharge voltage, discharge current, etc.). Thus, it should be appreciated that devices 100 provide redundancy to battery pack 1102c, as a reduction of electrical capacity of any device 100 in battery pack 1102c and/or a failure (e.g., malfunction, etc.) of any device 100 in battery pack 1102c will not affect the structure and/or functionality of battery pack 1102c and/or any other devices 100 in battery pack 1102c.

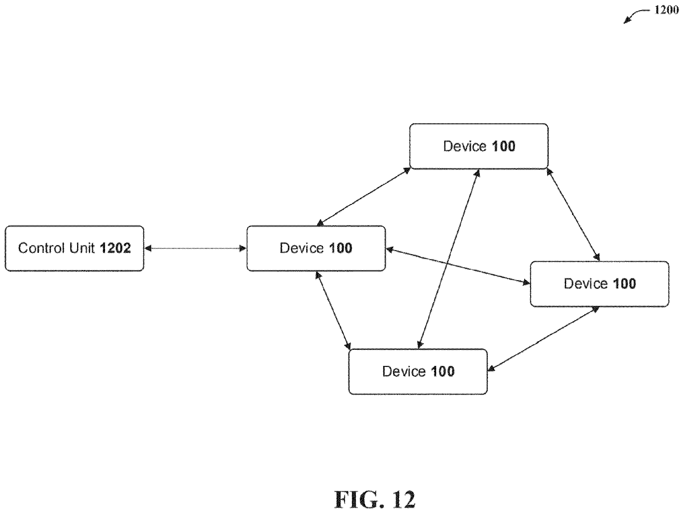

FIG. 12 illustrates an example, non-limiting system 1200 that can facilitate an intelligent battery cell with integrated monitoring and switching in accordance with one or more embodiments described herein. Repetitive description of like elements and/or processes employed in respective embodiments is omitted for sake of brevity.

System 1200 can include a mesh network (e.g., a local network topology having infrastructure nodes coupled directly, dynamically, and/or non-hierarchically to multiple nodes to cooperate with one another and/or to communicate data). System 1200 can include a control unit 1202 that can be coupled to one or more devices 100, where such one or more devices 100 can be further coupled to one another as illustrated in the example embodiment depicted in FIG. 12. Such coupling of control unit 1202 to one or more devices 100 and each device 100 to one or more other devices 100 can facilitate communication between all such components (e.g., via smart cell module 104 and/or network 112 as described above with reference to FIG. 1). For example, control unit 1202 can request, and/or each device 100 can periodically provide (e.g., every minute), parameter data (e.g., electric voltage, frequency, temperature, chemistry, etc.) from each device 100 that can be obtained by each such device 100 (e.g., via smart cell module 104 and/or one or more sensors 306 as described above with reference to FIG. 1).

In some embodiments, control unit 1202 can include a VCU (e.g., the VCU described above with reference to FIGS. 10A, 10B, and 10C) that can be implemented in and/or coupled to an electric driveline of an EV or HEV. In some embodiments, control unit 1202 can include and/or employ a BMS that can individually control (e.g., via smart cell module 104) functionality of each device 100 and/or functionality of a battery pack (e.g., battery pack 908) that can include one or more devices 100. For example, based on parameter data obtained from each device 100 in system 1200 as described above, control unit 1202 can perform one or more operations (e.g., operation mode reconfiguration, modify discharge priorities, etc.) to ensure a battery pack (e.g., battery pack 908) that can include devices 100 can maintain its discharge amount (e.g., discharge rate, discharge voltage, discharge current, etc.).

In some embodiments, system 1200 can include a multicore processing system and/or a distributed computing network system, where one or more functions of one or more nodes located inside or outside of system 1200 can be distributed to one or more nodes of system 1200. For example, one or more functions of control unit 1202 and/or a device (e.g., a computing device and/or communication device, not illustrated in FIG. 12) that is external to system 1200 can be transferred to one or more devices 100 of system 1200. In this example, such one or more devices 100 can then perform such one or more functions. Examples of such one or more functions include, but are not limited to: processing functions of control unit 1202, the external device, and/or one or more devices 100, thereby enabling parallel processing of such processing functions by such components; intelligent self-driving functions associated with a vehicle (e.g., an EV or HEV) including system 1200; detection and/or monitoring functions associated with such a vehicle including system 1200; and/or another function. To transfer such one or more functions to one or more devices 100 of system 1200, the external device described above can be coupled to control unit 1202 (e.g., via a wired connection, wireless connection, etc.) such that control unit 1202 can transfer such one or more functions received from the external device to one or more devices 100 of system 1200.

It should be appreciated that, based on such functionality transfer described above, system 1200 can enable cross connection between and/or redundancy associated with devices 100, control unit 1202, and/or one or more devices external to system 1200 (e.g., computing devices, communication devices, etc.). It should also be appreciated that, based on such cross connection and/or redundancy described above, system 1200 can facilitate elimination of one or more devices external to system 1200 that can transfer their functionality (e.g., processing functions, etc.) to control unit 1202 and/or one or more devices 100 of system 1200. For example, in embodiments where system 1200 is implemented in an EV or HEV and control unit 1202 includes a VCU, system 1200 can facilitate elimination of one or more computing devices and/or communication devices associated with and/or located in the EV or HEV, as the functionality of such devices can be transferred to control unit 1202 and/or one or more devices 100 of system 1200.

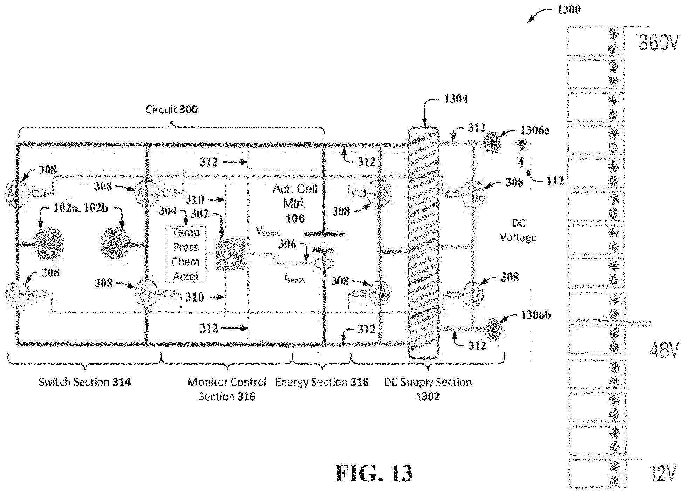

FIG. 13 illustrates an example, non-limiting circuit 1300 that can facilitate an intelligent battery cell with integrated monitoring and switches in accordance with one or more embodiments described herein. Repetitive description of like elements and/or processes employed in respective embodiments is omitted for sake of brevity.

In some embodiments, device 100 can include a DC supply section (not illustrated in FIG. 1). In these embodiments, circuit 1300 can include an electrical circuit representation of such a device 100 that can include a DC supply section. For example, circuit 1300 can include an example, non-limiting alternative embodiment of circuit 300 described above with reference to FIG. 3, where circuit 1300 can include a DC supply section 1302 as illustrated in the example embodiment depicted in FIG. 13.

DC supply section 1302 can include a transformer 1304 that can be coupled to circuit 300 and/or cell poles 1306a, 1306b via one or more switches 308 and/or wire traces 312 of DC supply section 1302 as illustrated in the example embodiment depicted in FIG. 13. Cell poles 1306a, 1306b can include the same structure and/or functionality as that of cell poles 102a, 102b described above with reference to FIG. 1.

Transformer 1304 can include a push-pull transformer or another transformer. Transformer 1304 can enable coupling (e.g., via cell poles 1306a, 1306b) of a DC electronic device to a device 100 that includes DC supply section 1302, where such DC coupling of the DC electronic device can be independent from and/or insulated from (e.g., electrically independent from and/or electrically insulated from) the AC supply that can be provided using device 100 (e.g., as described above with reference to FIGS. 3-9). Transformer 1304 can be controlled (e.g., operated) by processor 302 using one or more switches 308 of DC supply section 1302.

A single device 100 including DC supply section 1302 can provide DC electric voltage that can range from, for example, approximately 4V to approximately 48V. To provide DC electric voltage of 12V, 48V, and/or 400V, multiple devices 100 that respectively include DC supply section 1302 can be coupled to one another in series and parallel in a battery string (e.g., string 910) of a battery pack (e.g., battery pack 908). To provide redundancy, such a battery pack can include several (e.g., three) of the battery strings described above.

It should be appreciated that each device 100 in a battery pack (e.g., battery pack 908) can include DC supply section 1302 and the AC supply section described above with reference to FIGS. 3-9 (e.g., the AC supply section represented by circuit 300 of circuit 1300 depicted in FIG. 13). It should also be appreciated that DC supply section 1302 and the AC supply section of each device 100 in such a battery pack can operate in parallel (e.g., simultaneously) to provide a DC electric energy supply and an AC electric energy supply from the battery pack (e.g., at a DC terminal and an AC terminal, respectively, of such a battery pack), which can thereby enable elimination of one or more electronic components associated with an electronic system including such a device 100 and/or such a battery pack. For example, in embodiments where a device 100 including DC supply section 1302 is implemented in an electric driveline of an EV or HEV, such a device 100 including DC supply section 1302 can provide AC electric power (e.g., as described above with reference to FIGS. 3-9) to operate one or more motors of the EV or HEV (e.g., AC electric power to drive the EV or HEV) and DC electric power to operate one or more auxiliary electronic systems of the electric driveline and/or the EV or HEV, thereby enabling elimination of one or more electronic components associated with such one or more auxiliary electronic systems, the electric driveline, and/or the EV or HEV. For instance, in these embodiments, such a device 100 including DC supply section 1302 can provide DC electric power to operate one or more auxiliary electronic systems in the EV or HEV such as, for example, a heating, ventilation, and air conditioning (HVAC) system, interior and/or exterior lighting systems, electrically powered windows and/or locks, audio systems, DC electric power supply ports, windshield wipers, and/or another auxiliary electronic system in the EV. In these embodiments, such a device 100 including DC supply section 1302 can thereby enable elimination of one or more electronic components including, but not limited to, a converter, an inverter, one or more DC batteries, and/or another component associated with such one or more auxiliary electronic systems, the electric driveline, and/or the EV or HEV.

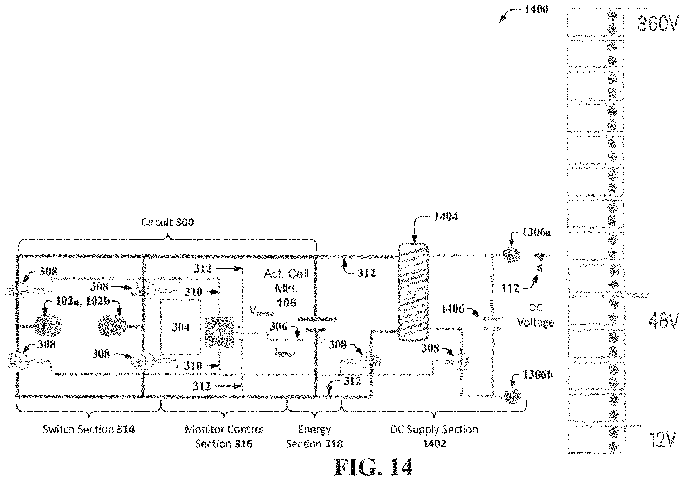

FIG. 14 illustrates an example, non-limiting circuit 1400 that can facilitate an intelligent battery cell with integrated monitoring and switching in accordance with one or more embodiments described herein. Repetitive description of like elements and/or processes employed in respective embodiments is omitted for sake of brevity.

In some embodiments, device 100 can include a DC supply section (not illustrated in FIG. 1). In these embodiments, circuit 1400 can include an electrical circuit representation of such a device 100 that can include a DC supply section. For example, circuit 1400 can include an example, non-limiting alternative embodiment of circuit 300 and/or circuit 1300 described above with reference to FIGS. 3 and 13, respectively, where circuit 1400 can include a DC supply section 1402 as illustrated in the example embodiment depicted in FIG. 14.

DC supply section 1402 can include an example, non-limiting alternative embodiment of DC supply section 1302. DC supply section 1402 can include a transformer 1404 that can be coupled to circuit 300, a capacitor 1406, and/or cell poles 1306a, 1306b via one or more switches 308 and/or wire traces 312 of DC supply section 1402 as illustrated in the example embodiment depicted in FIG. 14.

DC supply section 1402 can enable coupling (e.g., via cell poles 1306a, 1306b) of a DC electronic device to a device 100 that includes DC supply section 1402, where such DC coupling of the DC electronic device can be independent from and/or insulated from (e.g., electrically independent from and/or electrically insulated from) the AC supply that can be provided using device 100 (e.g., as described above with reference to FIGS. 3-9). It should be appreciated that such DC coupling of the DC electronic device can be independent from and/or insulated from the AC supply due to a magnetic field (not illustrated in FIG. 14) that can be generated in transformer 1404 (e.g., in the coil of transformer 1404) during operation of such a device 100 including DC supply section 1402.

Transformer 1404 can include a flyback transformer or another transformer. DC supply section 1402 and/or transformer 1404 can be controlled (e.g., operated) by processor 302 using one or more switches 308 of DC supply section 1402. Capacitor 1406 can store electric energy yielded by transformer 1404 via operation of one or more switches 308 of DC supply section 1402 (e.g., capacitor 1406 can store electric energy yielded by repeatedly actuating (e.g., turning on and off) one or more switches 308 of DC supply section 1402 at, for instance, 300kHz). DC supply section 1402 can provide such electric energy stored in capacitor 1406 to a DC electronic device that can be coupled to cell poles 1306a, 1306b.

The transformer ratio of transformer 1404 can include any ratio value that can enable a device 100 including DC supply section 1404 to yield a constant DC electric voltage ranging from, for example, approximately 4V to approximately 6V. For example, in an embodiment, the transformer ratio of transformer 1404 can include a 1:2 ratio. The transformer ratio of transformer 1404 can be adjusted to yield a desired constant DC electric voltage value. The DC electric voltage that can be yielded at cell poles 1306a, 1306b can be controlled by the duty cycle(s) corresponding to one or more switches 308 of DC supply section 1402 as described above, where such one or more switches 308 of DC supply section 1402 can be operated (e.g., opened, closed, turned on, turned off, engaged, disengaged, etc.) by processor 302.

It should be appreciated that each device 100 in a battery pack (e.g., battery pack 908) can include DC supply section 1402 and the AC supply section described above with reference to FIGS. 3-9 (e.g., the AC supply section represented by circuit 300 of circuit 1400 depicted in FIG. 14). It should also be appreciated that DC supply section 1402 and the AC supply section of each device 100 in such a battery pack can operate in parallel (e.g., simultaneously) to provide a DC electric energy supply and an AC electric energy supply from the battery pack (e.g., at a DC terminal and an AC terminal, respectively, of such a battery pack), which can thereby enable elimination of one or more electronic components associated with an electronic system including such a device 100 and/or such a battery pack. For example, in embodiments where a device 100 including DC supply section 1402 is implemented in an electric driveline of an EV or HEV, such a device 100 including DC supply section 1402 can provide AC electric power (e.g., as described above with reference to FIGS. 3-9) to operate one or more motors of the EV or HEV (e.g., AC electric power to drive the EV or HEV) and DC electric power to operate one or more auxiliary electronic systems of the electric driveline and/or the EV or HEV, thereby enabling elimination of one or more electronic components associated with such one or more auxiliary electronic systems, the electric driveline, and/or the EV or HEV. For instance, in these embodiments, such a device 100 including DC supply section 1402 can provide DC electric power to operate one or more auxiliary electronic systems in the EV or HEV such as, for example, a heating, ventilation, and air conditioning (HVAC) system, interior and/or exterior lighting systems, electrically powered windows and/or locks, audio systems, DC electric power supply ports, windshield wipers, and/or another auxiliary electronic system in the EV or HEV. In these embodiments, such a device 100 including DC supply section 1402 can thereby enable elimination of one or more electronic components including, but not limited to, a converter, an inverter, one or more DC batteries, and/or another component associated with such one or more auxiliary electronic systems, the electric driveline, and/or the EV or HEV.

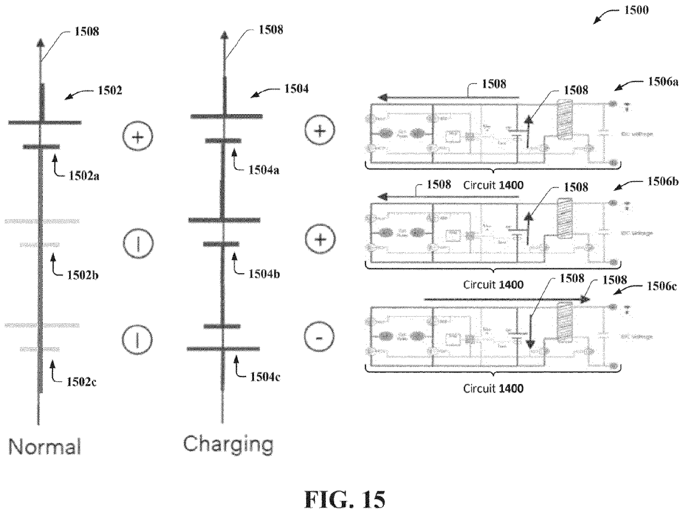

FIG. 15 illustrates an example, non-limiting diagram 1500 that can facilitate an intelligent battery cell with integrated monitoring and switching in accordance with one or more embodiments described herein. Repetitive description of like elements and/or processes employed in respective embodiments is omitted for sake of brevity.

Diagram 1500 can include strings 1502, 1504. Diagram 1500 can further include energy flow diagrams 1506a, 1506b, 1506c. Each of energy flow diagrams 1506a, 1506b, 1506c can include an energy flow diagram of circuit 1400 described above with reference to and illustrated in FIG. 14, where circuit 1400 can include an electrical circuit representation of a device 100 having DC supply section 1402.

Energy flow diagram 1506a can correspond to battery devices and/or battery cell devices 1502a, 1504a of strings 1502, 1504, respectively, where the energy flow direction in each of strings 1502, 1504 and energy flow diagram 1506a is represented by arrows 1508 as depicted in the example embodiment shown in FIG. 15. Energy flow diagram 1506b can correspond to battery devices and/or battery cell devices 1502b, 1504b of strings 1502, 1504, respectively, where the energy flow direction in each of strings 1502, 1504 and energy flow diagram 1506b is represented by arrows 1508 as depicted in the example embodiment shown in FIG. 15. Energy flow diagram 1506c can correspond to battery devices and/or battery cell devices 1502c, 1504c of strings 1502, 1504, respectively, where the energy flow direction in each of strings 1502, 1504 and energy flow diagram 1506c is represented by arrows 1508 as depicted in the example embodiment shown in FIG. 15.

String 1502 is an electrical diagram representing an example, non-limiting battery pack string that can include multiple battery devices and/or battery cell devices 1502a, 1502b, 1502c that can be coupled in series to yield a certain electric voltage. Battery devices and/or battery cell devices 1502a, 1502b, 1502c can each include the same structure and/or functionality as that of device 100 and/or smart cell module 104. String 1502 can illustrate the direction of energy flow in a normal mode (e.g., a discharge mode), where the energy flow direction is represented by arrow 1508 as depicted in the example embodiment shown in FIG. 15. In such a normal mode, battery device and/or battery cell device 1502a of string 1502 can be configured (e.g., as described above with reference to FIG. 4) to operate in positive mode 404 while battery devices and/or battery cell devices 1502b, 1502c of string 1502 can be configured (e.g., as described above with reference to FIG. 4) to operate in bypass mode 408.

String 1504 is an electrical diagram representing an example, non-limiting battery pack string that can include multiple battery devices and/or battery cell devices 1504a, 1504b, 1504c that can be coupled in series to yield a certain electric voltage. Battery devices and/or battery cell devices 1504a, 1504b, 1504c can each include the same structure and/or functionality as that of device 100 and/or smart cell module 104. String 1504 can illustrate the direction of energy flow in a charging mode (e.g., a reverse mode), where the energy flow direction is represented by arrow 1508 as depicted in the example embodiment shown in FIG. 15. In such a charging mode, battery devices and/or battery cell devices 1504a, 1504b of string 1504 can be configured (e.g., as described above with reference to FIG. 4) to operate in positive mode 404 while battery device and/or battery cell device 1504c of string 1504 can be configured (e.g., as described above with reference to FIG. 4) to operate in negative mode 406.

As described above, each battery device and/or battery cell device 1504a, 1504b, 1504c of string 1504 can include the same structure and/or functionality as that of a device 100 including DC supply section 1402, and string 1504 including such devices can be implemented in a battery pack (e.g., battery pack 908). In some embodiments, if a DC electric load (e.g., 12V load, 48V load, etc.) that can be coupled to DC supply section 1402 is relatively high and/or unbalance occurs in the battery pack, electric energy can be transferred between battery devices and/or battery cell devices 1504a, 1504b, 1504c in the charging mode (e.g., transferred on the AC supply side of such devices) as illustrated by string 1504 and energy flow diagrams 1506a, 1506b, 1506c illustrated in FIG. 15. In some embodiments, the above described battery pack (e.g., battery pack 908) that can include string 1504 can be implemented in an electric driveline of an EV or HEV. In these embodiments, such electric energy transfer described above can also be implemented, for instance, when the EV or HEV is static (e.g., in standstill, in parked position, motionless, etc.) and/or when the AC supply side of the above described battery pack and/or battery devices and/or battery cell devices 1504a, 1504b, 1504c is not operating (e.g., not propelling the EV or charging). I n these embodiments, the three phases of the 3-phase AC supply described above with reference to FIGS. 3-9 must not create a rotating magnetic field. It should be appreciated that such electric energy transfer described above can be implemented to ensure no devices 100 described herein in accordance with one or more embodiments of the present disclosure will be drained below a defined low level when providing a DC electric supply while the AC supply is not operating (e.g., not propelling an EV or HEV or charging).

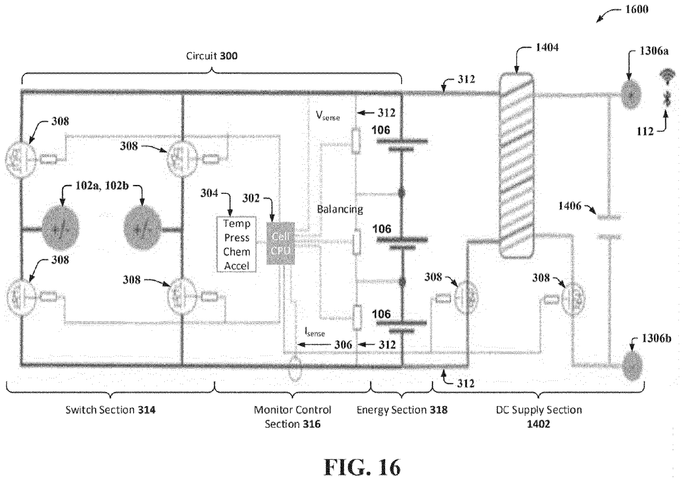

FIG. 16 illustrates an example, non-limiting circuit 1600 that can facilitate an intelligent battery cell with integrated monitoring and switching in accordance with one or more embodiments described herein. Repetitive description of like elements and/or processes employed in respective embodiments is omitted for sake of brevity.

In some embodiments, device 100 can include multiple active cell material 106 (e.g., multiple battery cells) that can be coupled to the same smart cell module 104 in device 100. In these embodiments, circuit 1600 can include an electrical circuit representation of such a device 100 that can include multiple active cell material 106 (e.g., multiple battery cells) that can be coupled to the same smart cell module 104. For example, circuit 1600 can include an example, non-limiting alternative embodiment of circuit 300, circuit 1300, and/or circuit 1400 described above with reference to FIGS. 3, 13, and 14, respectively, where circuit 1600 can include multiple active cell material 106 (e.g., three battery cells) that can be coupled to the same smart cell module 104 in a device 100 as illustrated in the example embodiment depicted in FIG. 16.

As illustrated in the example embodiment depicted in FIG. 16, device 100 can include, for instance, three active cell materials 106 that can be coupled to the same smart cell module 104. In this example embodiment, such active cell materials 106 can be coupled to one another in series and coupled to the same smart cell module 104 in parallel (e.g., via one or more components that can facilitate internal balancing (e.g., internal load balancing) as illustrated in FIG. 16). It should be appreciated that, in some embodiments, such a device 100 that can include multiple active cell materials 106 that can be coupled to the same smart cell module 104 in device 100 can enable elimination of one or more components associated with an electronic system including such a device 100 (e.g., by simultaneously providing DC power supply and AC power supply as described above with reference to FIGS. 13 and 14).

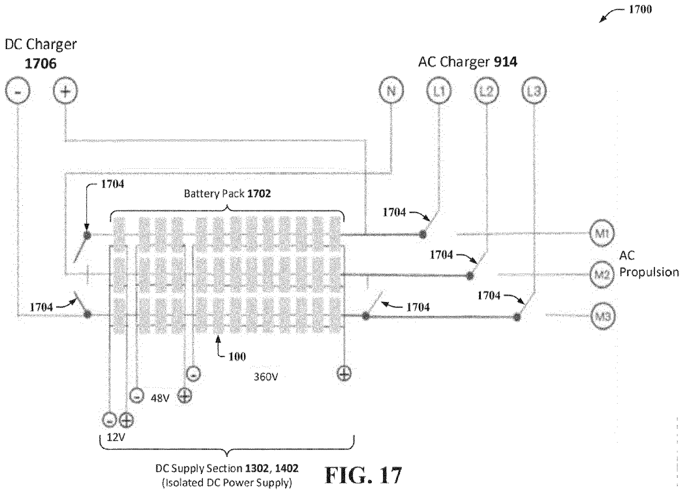

FIG. 17 illustrates an example, non-limiting wire diagram 1700 that can facilitate an intelligent battery cell with integrated monitoring and switching in accordance with one or more embodiments described herein. Repetitive description of like elements and/or processes employed in respective embodiments is omitted for sake of brevity.

Wire diagram 1700 illustrates how one or more embodiments of the present disclosure can be implemented in an electrical system to facilitate one or more functions of such one or more embodiments described above with reference to FIGS. 1-16. In the example embodiment depicted in FIG. 17, wire diagram 1700 illustrates how one or more embodiments of the present disclosure can be implemented in, for example, an electric driveline of an EV or HEV to facilitate one or more functions of such one or more embodiments described above with reference to FIGS. 1-16.

With reference to the example embodiments described above and illustrated in FIGS. 3-9 and 13-15, an isolated DC power supply (e.g., 12V, 48V, 360V, etc.) can be extracted (e.g., via cell poles 1306a, 1306b) from a battery pack 1702 of wire diagram 1700. Battery pack 1702 can include multiple devices 100 including DC supply section 1302 and/or DC supply section 1402. For clarity, only one of such devices 100 is identified in wire diagram 1700 depicted in FIG. 17. Battery pack 1702 can include the same structure and/or functionality as that of battery pack 908 described above with reference to FIG. 9. Such an isolated DC power supply can be extracted from battery pack 1702 by, for instance: respectively configuring (e.g., via processor 302) one or more devices 100 of battery pack 1702 in a certain operation mode 400 (e.g., off mode 402, positive mode 404, negative mode 406, or bypass mode 408) as described above with reference to FIGS. 3-9; and/or operating (e.g., via control unit 1202, a BMS, etc.) one or more switches 1704 of wire diagram 1700 to couple (e.g., in series) at least two of such devices 100 described above and/or to discharge DC electric energy (e.g., electric power, electric voltage, electric current, etc.) from one or more of such devices 100 described above.

With reference to the example embodiments described above and illustrated in FIGS. 3-9 and 13-15, an isolated AC power supply can be extracted from battery pack 1702 of wire diagram 1700. Such an isolated AC power supply can be extracted from battery pack 1702 by, for instance: respectively configuring (e.g., via processor 302) one or more devices 100 of battery pack 1702 in a certain operation mode 400 (e.g., off mode 402, positive mode 404, negative mode 406, or bypass mode 408) as described above with reference to FIGS. 3-9; and/or operating (e.g., via control unit 1202, a BMS, etc.) one or more switches 1704 of wire diagram 1700 to couple (e.g., in parallel) at least two of such devices 100 described above and/or to discharge AC electric energy (e.g., electric power, electric voltage, electric current, etc.) from one or more of such devices 100 described above. As illustrated in the example embodiment depicted in FIG. 17, such AC electric energy can be used as AC propulsion energy to power one or more motors M1, M2, M3 shown in wire diagram 1700, where such one or more motors M1, M2, M3 can be used to propel (e.g., drive) the EV or HEV. In some embodiments, one or more of such devices 100 described above and/or one or more switches 1704 can be configured and/or operated such that this AC power supply can be provided to one or more motors M1, M2, M3 at the same time (e.g., simultaneously, in parallel, etc.) as the above described isolated DC power supply is provided (e.g., at the same time the isolated DC power supply is provided to cell poles 1306a, 1306b).

With reference to the example embodiments described above and illustrated in FIGS. 3-9 and 13-15, AC charger 914 can be coupled to battery pack 1702 of wire diagram 1700 to charge battery pack 1702 and/or one or more of such devices 100 described above using an AC power supply from AC charger 914. AC charger 914 can charge battery pack 1702 and/or one or more of such devices 100 described above by, for instance: respectively configuring (e.g., via processor 302) one or more devices 100 of battery pack 1702 in a certain operation mode 400 (e.g., off mode 402, positive mode 404, negative mode 406, or bypass mode 408) as described above with reference to FIGS. 3-9; and/or operating (e.g., via control unit 1202, a BMS, etc.) one or more switches 1704 of wire diagram 1700 such that at least two of the above described devices 100 in battery pack 1702 can be coupled (e.g., in parallel) in a manner that facilitates charging of battery pack 1702 and/or one or more of such devices 100 using the AC power supply from AC charger 914. In some embodiments, one or more of such devices 100 described above and/or one or more switches 1704 can be configured and/or operated such that the AC power supply from AC charger 914 can be provided to battery pack 1702 and/or such one or more devices 100 at the same time (e.g., simultaneously, in parallel, etc.) as the above described isolated DC power supply is provided (e.g., at the same time the isolated DC power supply is provided to cell poles 1306a, 1306b).

With reference to the example embodiments described above and illustrated in FIGS. 3-9 and 13-15, DC charger 1706 can be coupled to battery pack 1702 of wire diagram 1700 to charge battery pack 1702 and/or one or more of such devices 100 described above using a DC power supply from DC charger 1706. DC charger 1706 can charge battery pack 1702 and/or one or more of such devices 100 described above by, for instance: respectively configuring (e.g., via processor 302) one or more devices 100 of battery pack 1702 in a certain operation mode 400 (e.g., off mode 402, positive mode 404, negative mode 406, or bypass mode 408) as described above with reference to FIGS. 3-9; and/or operating (e.g., via control unit 1202, a BMS, etc.) one or more switches 1704 of wire diagram 1700 such that at least two of the above described devices 100 in battery pack 1702 can be coupled (e.g., in series) in a manner that facilitates charging of battery pack 1702 and/or one or more of such devices 100 using the DC power supply from DC charger 1706.

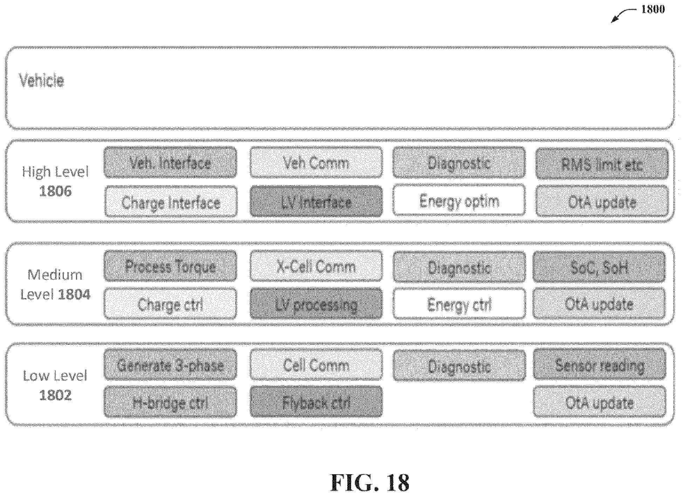

FIG. 18 illustrates an example, non-limiting diagram 1800 that can facilitate an intelligent battery cell with integrated monitoring and switching in accordance with one or more embodiments described herein. Repetitive description of like elements and/or processes employed in respective embodiments is omitted for sake of brevity.

Diagram 1800 can include a hierarchy of functions that can be performed in accordance with one or more embodiments of the present disclosure described herein. In some embodiments, diagram 1800 can include a low level 1802 of functions, a medium level 1804 of functions, and/or a high level 1806 of functions, where the complexity of such functions can increase from low level 1802 to high level 1806. For example, functions of low level 1802 can be less complex than those of medium level 1804 and functions of medium level 1804 can be less complex than those of high level 1806.

Low level 1802 can include low complexity functions that can be performed by, for instance, implementing one or more software applications that can facilitate such low complexity functions in low level 1802. For example, one or more software applications that can include a low level of complexity can be implemented to facilitate one or more functions of low level 1802 including, but not limited to: generating 3-phase (denoted as "Generate 3-phase" in FIG. 18); H-bridge control (denoted as "H-bridge ctrl" in FIG. 18); cell communication (denoted as "Cell Comm" in FIG. 18); flyback control (denoted as "Flyback ctrl" in FIG. 18); diagnostics (denoted as "Diagnostic" in FIG. 18); sensor reading; over-the-air updates (denoted as "OtA update" in FIG. 18); and/or another function.

Medium level 1804 can include medium complexity functions that can be performed by, for instance, implementing one or more software applications that can facilitate such medium complexity functions in medium level 1804. For example, one or more software applications that can include a medium level of complexity can be implemented to facilitate one or more functions of medium level 1804 including, but not limited to: processing torque (denoted as "Process Torque" in FIG. 18); charge control (denoted as "Charge ctrl" in FIG. 18); cross-cell communication (denoted as "X-Cell Comm" in FIG. 18); low voltage processing (denoted as "LV processing" in FIG. 18); diagnostics (denoted as "Diagnostic" in FIG. 18); energy control (denoted as "Energy ctrl" in FIG. 18); state of charge and/or state of health (denoted as "SoC, SoH" in FIG. 18); over-the-air updates (denoted as "OtA update" in FIG. 18); and/or another function.

High level 1806 can include high complexity functions that can be performed by, for instance, implementing one or more software applications that can facilitate such high complexity functions in high level 1806. For example, one or more software applications that can include a high level of complexity can be implemented to facilitate one or more functions of high level 1806 including, but not limited to: vehicle interface (denoted as "Veh. Interface" in FIG. 18); charge interface (denoted as "Charge Interface" in FIG. 18); vehicle communication (denoted as "Veh Comm" in FIG. 18); low voltage interface (denoted as "LV Interface" in FIG. 18); diagnostics (denoted as "Diagnostic" in FIG. 18); energy optimization (denoted as "Energy optim" in FIG. 18); root mean square (RMS) limit (denoted as "RMS limit etc" in FIG. 18); over-the-air updates (denoted as "OtA update" in FIG. 18); and/or another function.

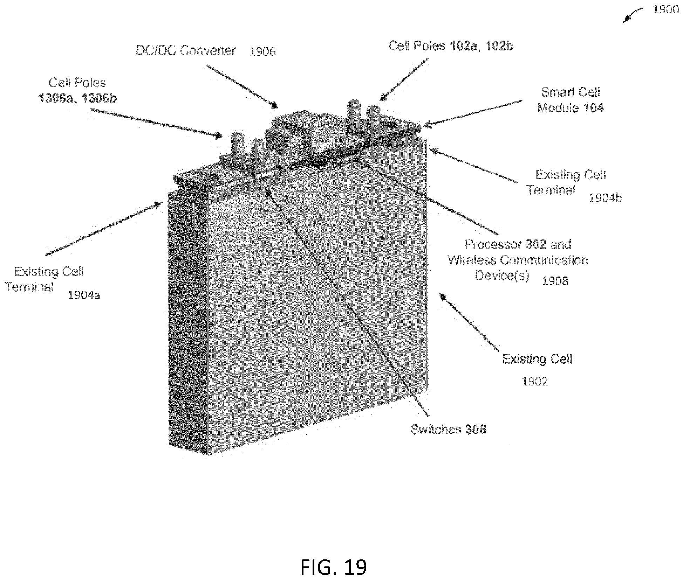

FIG. 19 illustrates a perspective view of an example, non-limiting device 1900 that can facilitate an intelligent battery cell with integrated monitoring and switching in accordance with one or more embodiments described herein. Repetitive description of like elements and/or processes employed in respective embodiments is omitted for sake of brevity.

Device 1900 illustrated in FIG. 19 can include an example, non-limiting alternative embodiment of device 100 described above with reference to FIG. 1. For example, as illustrated in the example embodiment depicted in FIG. 19, device 1900 can include an existing cell 1902 having smart cell module 104 coupled thereto (e.g., where smart cell module 104 can include an add-on component that can be coupled to an already existing battery cell (e.g., a standard battery cell) denoted as existing cell 1902 in FIG. 19). Existing cell 1902 can include the same structure and/or functionality as that of active cell material 106 described above with reference to FIG. 1.

As illustrated in the example embodiment depicted in FIG. 19, smart cell module 104 can be coupled to existing cell 1902 via existing cell terminals 1904a, 1904b. Existing cell terminals 1904a, 1904b can include the same structure and/or functionality as that of cell material poles 106a, 106b described above with reference to FIG. 1. In some embodiments, cell poles 102a, 102b (e.g., DC terminals) and/or cell poles 1306a, 1306b (e.g., AC terminals) can be formed on and/or coupled to smart cell module 104 as depicted in FIG 19. In some embodiments, cell poles 102a, 102b (e.g., DC terminals) and/or cell poles 1306a, 1306b (e.g., AC terminals) can be formed on and/or coupled to smart cell module 104 at another location on smart cell module 104 and/or in another orientation.

Device 1900 can further include a converter such as, for instance, a DC/DC converter 1906 that can be coupled to, formed on, and/or integrated with smart cell module 104. In an embodiment, DC/DC converter 1906 can be coupled to one or more components of device 100 and/or smart cell module 104 (e.g., to cell poles 102a, 102b, one or more switches 308, etc.). DC/DC converter 1906 can include a DC/DC converter or another type of converter. In some embodiments, DC/DC converter 1906 can be coupled to smart cell module 104, for example, as illustrated in FIG. 19. In some embodiments, DC/DC converter 1906 can be coupled to smart cell module 104 at another location on smart cell module 104 and/or in another orientation (e.g., vertically, etc.).

DC/DC converter 1906 can convert a source of DC voltage that can be yielded by device 100 and/or smart cell module 104 from one voltage level to another voltage level (e.g., from a lower DC voltage level to a higher DC voltage level or vice versa). In some embodiments, a battery pack (e.g., battery pack 908) that can include multiple device 100 can also include DC/DC converter 1906. In these embodiments, DC/DC converter 1906 can convert a source of DC voltage that can be yielded by such a battery pack (e.g., a source of DC voltage that can be yielded by one or more devices 100 in the battery pack) from one voltage level to another voltage level (e.g., from a lower DC voltage level to a higher DC voltage level or vice versa).

In the example embodiment depicted in FIG. 19, smart cell module 104 of device 1900 can include one or more wireless communication devices 1908. Such one or more wireless communication devices 1908 can include, for example, one or more transmitters, receivers, transceivers, antenna, and/or another wireless communication device that can facilitate wireless communication (e.g., via network 112) between multiple devices 1900 (e.g., as described above with reference to device 100 and FIGS. 1 and 3).

The various embodiments of the present disclosure described herein (e.g., devices 100, 200, 1900, circuits 300, 1300, 1400, 1600, electronic systems 902, 904, 906, 1000a, battery pack 1102c, system 1200, wire diagram 1700, etc.) can be associated with various technologies and provide various technological improvements. For example, the various embodiments of the present disclosure described herein (e.g., devices 100, 200, 1900, circuits 300, 1300, 1400, 1600, electronic systems 902, 904, 906, 1000a, battery pack 1102c, system 1200, wire diagram 1700, etc.) can be associated with battery device and/or battery cell device technologies, battery pack technologies, BMS technologies, electric driveline technologies, EV or HEV technologies, semiconducting and/or superconducting circuit technologies, computing device and/or communication device technologies, ML technologies, AI technologies, cloud computing technologies, and/or other technologies.

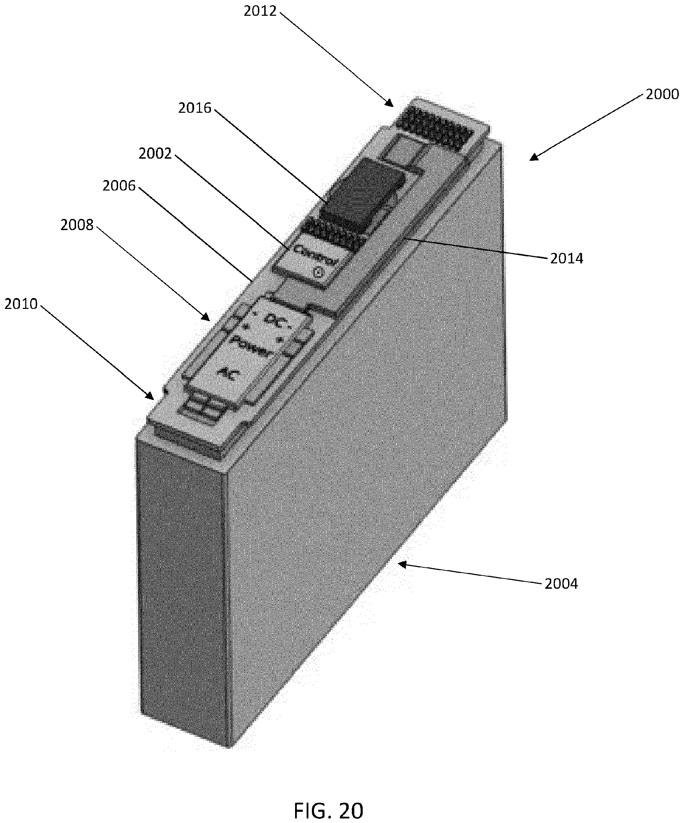

FIG. 20 is a perspective view of one illustrative embodiment of the intelligent battery assembly 2000 of the present disclosure, utilizing an individual integrated control and switching system. In this "1S" configuration, one controller 2002 is utilized per cell 2004. Thus, the controller 2002 may be integrated into the body of the cell 2004 itself, if so desired, providing superior modularity and bulk thermal management characteristics. The battery assembly 2000 includes a PCB 2006 coupled to the cell 2004 on which the controller 2002 (including processor and memory) is disposed. The switch 2008 is also coupled to the PCB 2006 adjacent to one of the poles 2010 of the cell 2004. Here, the switch 2008 may be a relatively inexpensive MOSFET with a low voltage rating, in general. Contact pads and/or short strips and/or busbars and PCB traces make all appropriate internal electrical connections near this pole 2010. The poles 2010, 2012 of the cell 2004 are coupled together via an elongated busbar 2014, which has the slight disadvantage of increasing inductance in the circuit and increasing the voltage rating of the MOSFETs 2008, as well as potentially covering any cell gas evacuation channels that are disposed between the poles 2010, 2012. The PCB 2006 also includes transformer 2016, any sensors utilized, any power supply components utilized, and/or any contact pads utilized. Thus, the PCB 2006 and associated components are physically coupled to or integrated with the cell 2004, with one controller 2002 per cell. Adjacent cells 2004 are coupled together (e.g., in series) via appropriate short busbars and/or wires.

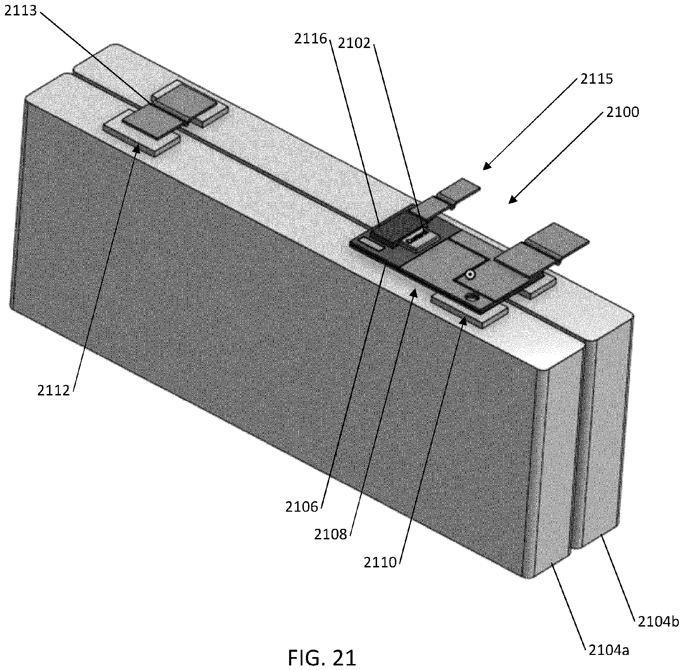

FIG. 21 is a perspective view of one illustrative embodiment of the intelligent multi-cell battery assembly 2100 of the present disclosure, utilizing a shared integrated control and switching system. In this "2S" configuration, one controller 2102 is utilized per pair of cells 2104a, 2104b. Thus, the controller 2102 may be coupled to the bodies of the cells 2104a, 2104b themselves, providing advantageous modularity and thermal management characteristics. The battery assembly 2100 includes a PCB 2106 coupled to the cells 2104a, 2104b on which the controller 2102 (including processor and memory) is disposed. The switches 2108 (here two) are also coupled to the PCB 2106 adjacent to one of the poles 2110 of each of the cells 2104a, 2104b. Here, the switches 2008 may be a relatively inexpensive MOSFETs with a low voltage rating, in general. Contact pads and/or short strips and/or busbars and PCB traces make all appropriate internal electrical connections near these poles 2110. The poles 2110, 2112 of each of the cells 2104a, 2104b are coupled together via a wire or the like, which advantageously does not cover any cell gas evacuation channels that are disposed between the poles 2110, 2112. Here, like poles 2012 of each cell 2104a, 2104b are coupled together by a short busbar 2113 with relatively low stray inductance. Again, the PCB 2106 also includes transformer 2116, any sensors utilized, any power supply components utilized, and/or any contact pads utilized. Thus, the PCB 2106 and associated components are physically coupled to or integrated with the pair of cells 2104a, 2104b, with one controller 2102 per cell pair. Adjacent pairs of cells 2104a, 2104b are coupled together (e.g., in series) via appropriate short busbars 2115 and/or wires. Here, as opposed to the 1S configuration, cell balancing functionality is required in the controller 2102, but stray inductance, voltage gain, and footprint are reduced due to the absence of the elongated busbar 2014 (FIG. 20) and the coupled cells 2104a, 2104b. This specific configuration is described in greater detail herein below. Specifically, inputs (i.e., cell connected bars) outputs (i.e., surfaces connected to the next cell) may be stacked close to the MOSFETs 2102, further reducing stray inductance and improving thermal cooling characteristics. In general, limiting pole to pole connection on the same cell minimizes stray inductance, as does the copper-MOSFET-copper switch configuration, which also enhances thermal management, with each cell itself acting as a heatsink that is cooled in a conventional manner. Advantageously, in the 2S configuration, cell redundancy is inherently provided.

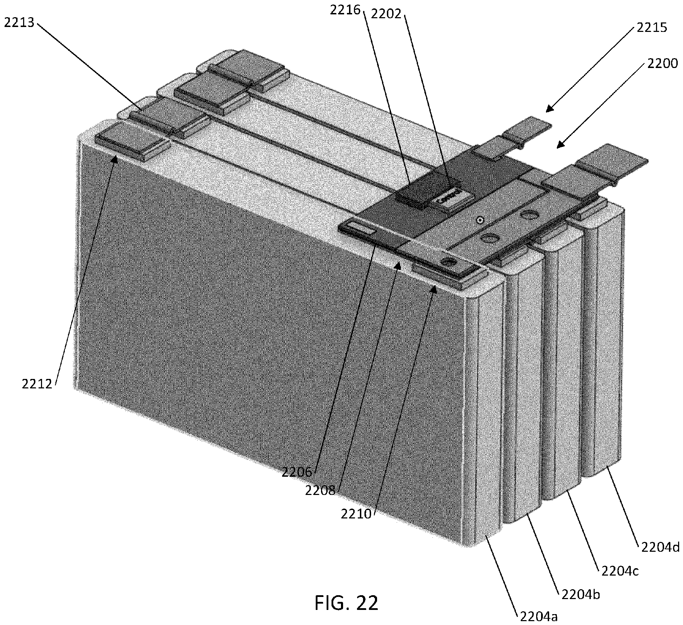

FIG. 22 is a perspective view of another illustrative embodiment of the intelligent multi-cell battery assembly 2200 of the present disclosure, utilizing a shared integrated control and switching system. In this "4S" configuration, one controller 2202 is utilized per group of four cells 2204a, 2204b, 2204c, 2204d. Other numbers of cells could be used equally, although with varying degrees of complexity and success. Thus, the controller 2202 may be coupled to the bodies of the cells 2204a, 2204b, 2204c, 2204d themselves, again providing advantageous modularity and thermal management characteristics. The battery assembly 2200 includes a PCB 2206 coupled to the cells 2204a, 2204b, 2204c, 2204d on which the controller 2202 (including processor and memory) is disposed. The switches 2208 (here four) are also coupled to the PCB 2206 adjacent to one of the poles 2210 of each of the cells 2204a, 2204b, 2204c, 2204d. Here, the switches 2208 may be a relatively inexpensive MOSFETs with a low voltage rating, in general. Contact pads and/or short strips and/or busbars and PCB traces make all appropriate internal electrical connections near these poles 2210. The poles 2210, 2212 of each of the cells 2204a, 2204b, 2204c, 2204d are coupled together via a wire or the like, which advantageously does not cover any cell gas evacuation channels that are disposed between the poles 2210, 2212. Fewer such connections are required in the 4S configuration than in the 2S configuration (e.g., two for four cells, instead of two for two cells), as a middle short busbar can be integrated into the PCB 2206 Here, like poles 2212 of select cells 2204a, 2204b, 2204c, 2204d are coupled together by a short busbar 2213 with relatively low stray inductance. Again, the PCB 2206 also includes transformer 2216, any sensors utilized, any power supply components utilized, and/or any contact pads utilized. Thus, the PCB 2206 and associated components are physically coupled to or integrated with the grouping of cells 2204a, 2204b, 2204c, 2204d, with one controller 2102 per cell group. Adjacent groupings of cells 2204a, 2204b, 2204c, 2204d are coupled together (e.g., in series) via appropriate short busbars 2215 and/or wires. Here, as opposed to the 1S configuration, cell balancing functionality is again required in the controller 2202, but stray inductance, voltage gain, and footprint are still reduced due to the absence of the elongated busbar 2014 (FIG. 20) and the coupled cells 2204a, 2204b, 2204c, 2204d. This specific configuration is described in greater detail herein below. Specifically, inputs (i.e., cell connected bars) outputs (i.e., surfaces connected to the next cell) may be stacked close to the MOSFETs 2202, further reducing stray inductance and improving thermal cooling characteristics. In general, limiting pole to pole connection on the same cell minimizes stray inductance, as does the copper-MOSFET-copper switch configuration, which also enhances thermal management, with each cell itself acting as a heatsink that is cooled in a conventional manner. Advantageously, in the 4S configuration, cell redundancy is inherently provided.

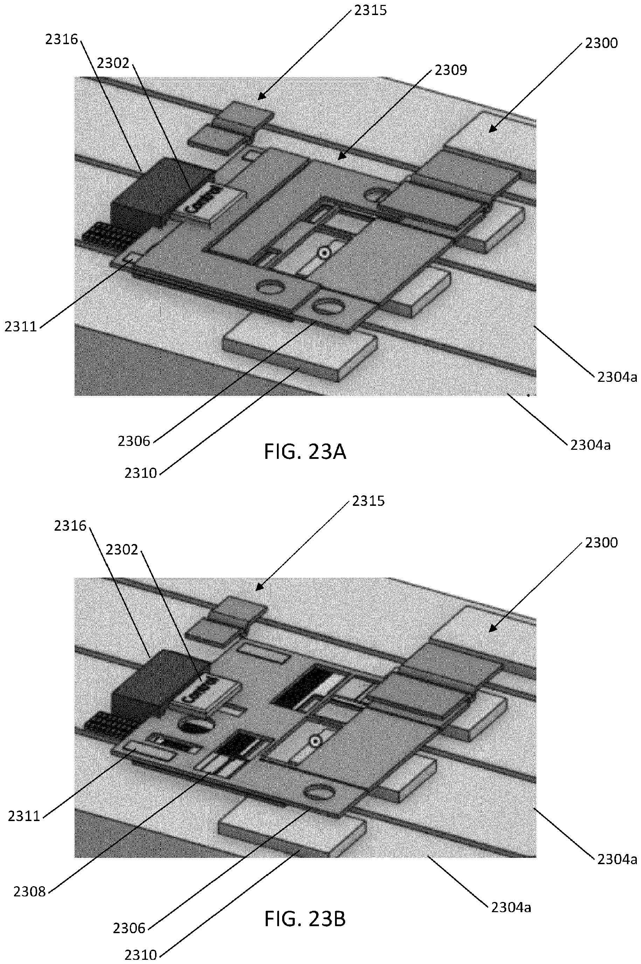

FIGS. 23A and 23B are perspective views of the intelligent multi-cell battery assembly 2300 of FIG. 21 in various states of assembly. In this 2S configuration, the one controller 2302 is coupled to the PCB 2306 and utilized per pair of cells 2304a, 2304b. The switches 2308 (here two) are also coupled to the PCB 2306 adjacent to one of the poles 2310 of each of the cells 2104a, 2104b. Connections of the various components to the poles 2310 are made via multiple busbars 2309 disposed above and below the PCB 2306. Contact pads 2311 are provided on the PCB 2306 for linking adjacent units. Again, the PCB 2306 also includes transformer 2316, any sensors utilized, any power supply components utilized, and/or any other contact pads utilized. Thus, the PCB 2306 and associated components are physically coupled to or integrated with the pair of cells 2304a, 2304b, with one controller 2302 per cell pair. Adjacent pairs of cells 2304a, 2304b are coupled together (e.g., in series) via appropriate short busbars 2315 and/or wires. As is illustrated, the inputs (i.e., cell connected bars) outputs (i.e., surfaces connected to the next cell) are stacked close to the MOSFETs 2302, further reducing stray inductance and improving thermal cooling characteristics.

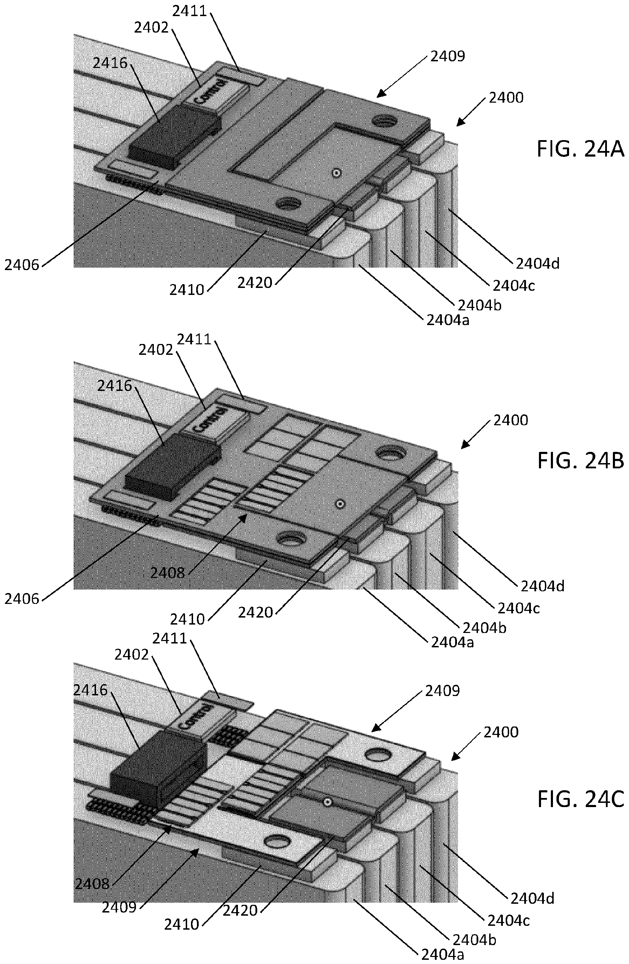

FIGS. 24A-24C are perspective views of the intelligent multi-cell battery assembly 2400 of FIG. 22 in various states of assembly. In this 4S configuration, the one controller 2402 is coupled to the PCB 2406 and utilized per grouping of cells 2404a, 2404b, 2404c, 2404d. The switches 2408 (here four) are also coupled to the PCB 2406 adjacent to one of the poles 2410 of each of the cells 2404a, 2404b, 2404c, 2404d. Connections of the various components to the poles 2410 are made via multiple busbars 2409 disposed above and below the PCB 2406. Contact pads 2411 are provided on the PCB 2406 for linking adjacent units. Again, the PCB 2406 also includes transformer 2416, any sensors utilized, any power supply components utilized, and/or any other contact pads utilized. Thus, the PCB 2406 and associated components are physically coupled to or integrated with the grouping of cells 2404a, 2404b, 2404c, 2404d, with one controller 2402 per cell grouping. Adjacent groupings of cells 2404a, 2404b, 2404c, 2404d are coupled together (e.g., in series) via appropriate short busbars and/or wires. As is illustrated, the inputs (i.e., cell connected bars) outputs (i.e., surfaces connected to the next cell) are stacked close to the MOSFETs 2402, further reducing stray inductance and improving thermal cooling characteristics. Here, pole-to-pole wires are limited via the use of a coupling busbar 2420 disposed between cells 2404b, 2404c.

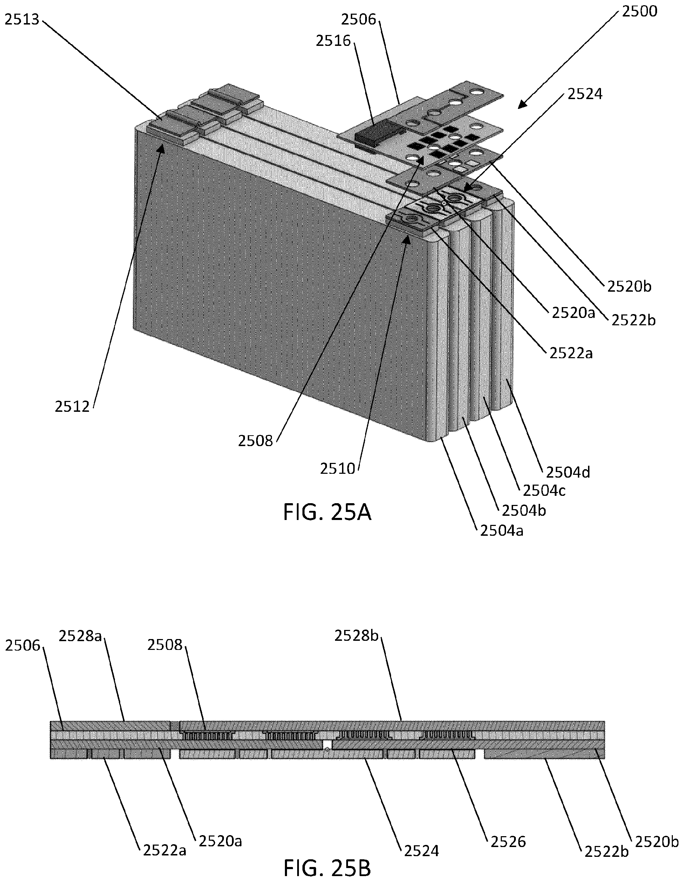

FIGS. 25A and 25B are perspective and cross-sectional end views of a further illustrative embodiment of the intelligent multi-cell battery assembly 2500 of the present disclosure, utilizing a shared integrated control and switching system in a component version. In this "4S" configuration, one controller is utilized per group of four cells 2504a, 2504b, 2504c, 2504d. Other numbers of cells could be used equally, although with varying degrees of complexity and success. Thus, the controller may be coupled to the bodies of the cells 2504a, 2504b, 2504c, 2504d themselves, again providing advantageous modularity and thermal management characteristics. The battery assembly 2500 includes a PCB 2506 coupled to the cells 2504a, 2504b, 2504c, 2504d on which the controller (including processor and memory) is disposed. The switches 2508 (here eight) are also coupled to the PCB 2506 adjacent to one of the poles 2510 of each of the cells 2504a, 2504b, 2504c, 2504d. Here, the switches 2508 may be a relatively inexpensive MOSFETs with a low voltage rating, in general. Contact pads and/or short strips and/or busbars and PCB traces make all appropriate internal electrical connections near these poles 2510. The poles 2510, 2512 of each of the cells 2504a, 2504b, 2504c, 2504d are coupled together via a wire or the like, which advantageously does not cover any cell gas evacuation channels that are disposed between the poles 2510, 2512. Fewer such connections are required in the 4S configuration than in the 2S configuration (e.g., two for four cells, instead of two for two cells), as a middle short busbar can be integrated into the PCB 2506 Here, like poles 2512 of select cells 2504a, 2504b, 2504c, 2504d are coupled together by a short busbar 2513 with relatively low stray inductance. Again, the PCB 2506 also includes transformer 2516, any sensors utilized, any power supply components utilized, and/or any contact pads utilized. Thus, the PCB 2506 and associated components are physically coupled to or integrated with the grouping of cells 2504a, 2504b, 2504c, 2504d, with one controller per cell group, for example. Adjacent groupings of cells 2504a, 2504b, 2504c, 2504d are coupled together (e.g., in series) via appropriate short busbars and/or wires. Here, as opposed to the 1S configuration, cell balancing functionality is again required in the controller, but stray inductance, voltage gain, and footprint are still reduced due to the absence of the elongated busbar 2014 (FIG. 20) and the coupled cells 2504a, 2504b, 2504c, 2504d. This specific configuration is described in greater detail herein below. Specifically, inputs (i.e., cell connected bars) outputs (i.e., surfaces connected to the next cell) may be stacked close to the MOSFETs 2508, further reducing stray inductance and improving thermal cooling characteristics. In general, limiting pole to pole connection on the same cell minimizes stray inductance, as does the copper-MOSFET-copper switch configuration, which also enhances thermal management, with each cell itself acting as a heatsink that is cooled in a conventional manner. Advantageously, in the 4S configuration, cell redundancy is inherently provided. Here, the MOSFETs 2508 are pre-mounted to the PCB 2506 which is disposed above two short busbars 2520a, 2520b that couple cells 2504a, 2504b and 2504c, 2504d, respectively, through the MOSFETs 2508. The busbars 2520a, 2520b are coupled to the respective poles 2510 of cells 2504a, 2504c via flexure connection 2522a and connection 2522b. The PCB 2506 is also disposed above a bridge bar 2524 that couples cells 2504b, 2504c and is separated from the PCB 2506 by an intervening insulating layer 2526. This bridge bar 2524 may also incorporate appropriate flexure connections. Above the PCB 2506, two additional busbars 2528a, 2528b selectively couple the MOSFETs 2508, as in other embodiments. In this case, one busbar 2528a couples a first row of MOSFETs 2508 and another busbar 2528b couples a second row of MOSFETs 2508. The lower conductive layer acts as an input layer, while the upper conductive layer acts as an output layer. The MOSFETs are prepared and sintered (drain) to the busbars. A pre-soldered source and gate are provided. The PCB is prepared with 2.5D technology for pockets. Two-sided soldering to the PCB is provided with prepared grooves for the MOSFETs.

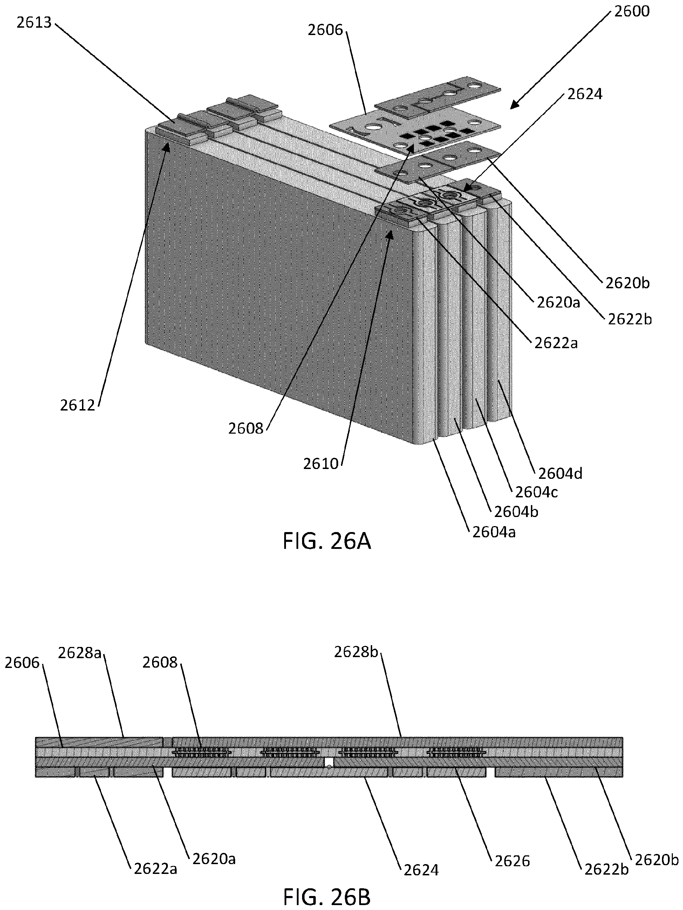

FIGS. 26A and 26B are perspective and cross-sectional end views of a further illustrative embodiment of the intelligent multi-cell battery assembly 2600 of the present disclosure, utilizing a shared integrated control and switching system in an embedded version. In this "4S" configuration, one controller is utilized per group of four cells 2604a, 2604b, 2604c, 2604d. Other numbers of cells could be used equally, although with varying degrees of complexity and success. Thus, the controller may be coupled to the bodies of the cells 2604a, 2604b, 2604c, 2604d themselves, again providing advantageous modularity and thermal management characteristics. The battery assembly 2600 includes a PCB 2606 coupled to the cells 2604a, 2604b, 2604c, 2604d on which the controller (including processor and memory) is disposed. The switches 2608 (here eight) are also coupled to the PCB 2606 adjacent to one of the poles 2610 of each of the cells 2604a, 2604b, 2604c, 2604d. Here, the switches 2608 may be a relatively inexpensive MOSFETs with a low voltage rating, in general. Contact pads and/or short strips and/or busbars and PCB traces make all appropriate internal electrical connections near these poles 2610. The poles 2610, 2612 of each of the cells 2604a, 2604b, 2604c, 2604d are coupled together via a wire or the like, which advantageously does not cover any cell gas evacuation channels that are disposed between the poles 2610, 2612. Fewer such connections are required in the 4S configuration than in the 2S configuration (e.g., two for four cells, instead of two for two cells), as a middle short busbar can be integrated into the PCB 2606 Here, like poles 2612 of select cells 2604a, 2604b, 2604c, 2604d are coupled together by a short busbar 2613 with relatively low stray inductance. Again, the PCB 2606 also includes transformer, any sensors utilized, any power supply components utilized, and/or any contact pads utilized. Thus, the PCB 2606 and associated components are physically coupled to or integrated with the grouping of cells 2604a, 2604b, 2604c, 2604d, with one controller per cell group, for example. Adjacent groupings of cells 2604a, 2604b, 2604c, 2604d are coupled together (e.g., in series) via appropriate short busbars and/or wires. Here, as opposed to the 1S configuration, cell balancing functionality is again required in the controller, but stray inductance, voltage gain, and footprint are still reduced due to the absence of the elongated busbar 2014 (FIG. 20) and the coupled cells 2604a, 2604b, 2604c, 2604d. This specific configuration is described in greater detail herein below. Specifically, inputs (i.e., cell connected bars) outputs (i.e., surfaces connected to the next cell) may be stacked close to the MOSFETs 2608, further reducing stray inductance and improving thermal cooling characteristics. In general, limiting pole to pole connection on the same cell minimizes stray inductance, as does the copper-MOSFET-copper switch configuration, which also enhances thermal management, with each cell itself acting as a heatsink that is cooled in a conventional manner. Advantageously, in the 4S configuration, cell redundancy is inherently provided. Here, the MOSFETs 2608 are pre-mounted to the PCB 2606 which is disposed above two short busbars 2620a, 2620b that couple cells 2604a, 2604b, 2604c, 2604d, respectively, through the MOSFETs 2608. The busbars 2620a, 2620b are coupled to the respective poles 2610 of cells 2604a, 2604c via flexure connection 2622a and connection 2622b. The PCB 2606 is also disposed above a bridge bar 2624 that couples cells 2604b, 2604c and is separated from the PCB 2606 by an intervening insulating layer 2626. This bridge bar 2624 may also incorporate appropriate flexure connections. Above the PCB 2606, two additional busbars 2628a, 2628b selectively couple the MOSFETs 2608, as in other embodiments. In this case, one busbar 2628a couples a first row of MOSFETs 2608 and another busbar 2628b couples a second row of MOSFETs 2608. The lower conductive layer acts as an input layer, while the upper conductive layer acts as an output layer. Here, the bare die MOSFET is manufactured and surface prepared and the MOSFETs are embedded in the PCB. Two-sided soldering of the busbars onto the PCB outer sides is performed.

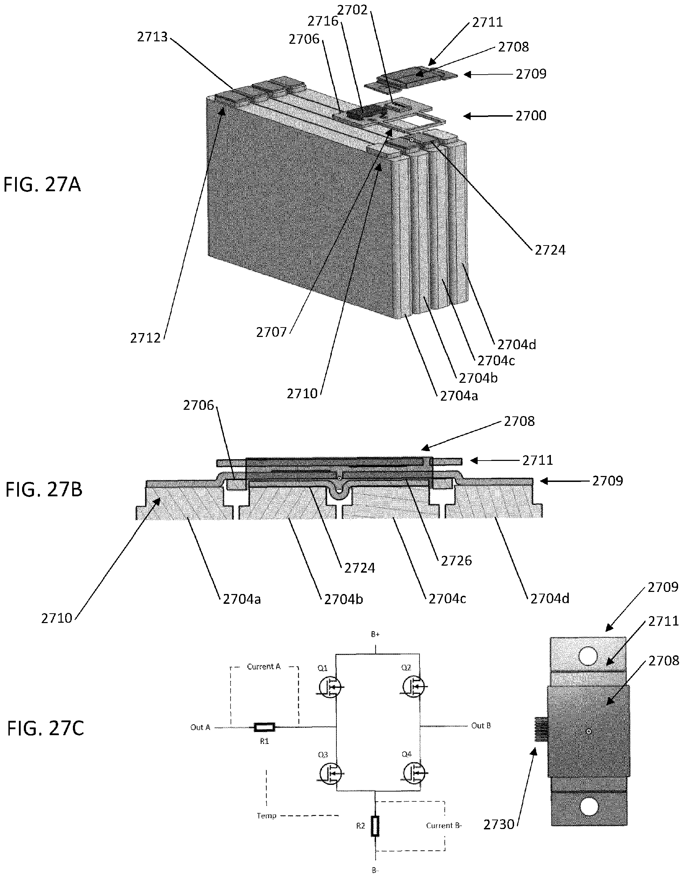

FIGS. 27A-27C are perspective and cross-sectional end views and a circuit diagram of a further illustrative embodiment of the intelligent multi-cell battery assembly 2700 of the present disclosure, utilizing a shared integrated control and switching system in a module version. In this "4S" configuration, one controller 2702 is utilized per group of four cells 2704a, 2704b, 2704c, 2704d. Other numbers of cells could be used equally, although with varying degrees of complexity and success. Thus, the controller 2702 may be coupled to the bodies of the cells 2704a, 2704b, 2704c, 2704d themselves, again providing advantageous modularity and thermal management characteristics. The battery assembly 2700 includes a PCB 2706 coupled to the cells 2704a, 2704b, 2704c, 2704d on which the controller 2702 (including processor and memory) is disposed. Here, the switches 2708 are provided in a module disposed adjacent to one of the poles 2710 of each of the cells 2704a, 2704b, 2704c, 2704d. Here, the switches 2608 may be a relatively inexpensive MOSFETs with a low voltage rating, in general. Contact pads and/or short strips and/or busbars and PCB traces make all appropriate internal electrical connections near these poles 2710. The poles 2710, 2712 of each of the cells 2704a, 2704b, 2704c, 2704d are coupled together via a wire or the like, which advantageously does not cover any cell gas evacuation channels that are disposed between the poles 2710, 2712. Fewer such connections are required in the 4S configuration than in the 2S configuration (e.g., two for four cells, instead of two for two cells), as a middle short busbar can be integrated into the PCB 2706 Here, like poles 2712 of select cells 2704a, 2704b, 2704c, 2704d are coupled together by a short busbar 2713 with relatively low stray inductance. Again, the PCB 2706 also includes transformer 2716, any sensors utilized, any power supply components utilized, and/or any contact pads utilized. Thus, the PCB 2706 and associated components are physically coupled to or integrated with the grouping of cells 2704a, 2704b, 2704c, 2704d, with one controller 2702 per cell group, for example. Adjacent groupings of cells 2704a, 2704b, 2704c, 2704d are coupled together (e.g., in series) via appropriate short busbars and/or wires. Here, as opposed to the 1S configuration, cell balancing functionality is again required in the controller 2702, but stray inductance, voltage gain, and footprint are still reduced due to the absence of the elongated busbar 2014 (FIG. 20) and the coupled cells 2704a, 2704b, 2704c, 2704d. This specific configuration is described in greater detail herein below. Specifically, inputs (i.e., cell connected bars) outputs (i.e., surfaces connected to the next cell) may be stacked close to the MOSFETs 2708, further reducing stray inductance and improving thermal cooling characteristics. In general, limiting pole to pole connection on the same cell minimizes stray inductance, as does the copper-MOSFET-copper switch configuration, which also enhances thermal management, with each cell itself acting as a heatsink that is cooled in a conventional manner. Advantageously, in the 4S configuration, cell redundancy is inherently provided. Here, the MOSFETs 2708 are preassembled in the module, which is disposed above a short busbar 2724 that couples cells 2704b, 2604c. The short busbar 2726 may be thermally coupled to the module 2706 via an intervening thermally conductive layer or tape 2726 and a frame 2707 of the PCB 2706 is disposed about select poles 2710 and/or the short busbar 2726 to hold the components in place, with the module 2708 disposed above the short busbar 2724. As illustrated, each side of the module 2708 includes a bent conductive flange 2709 by which the module 2708 is coupled to the poles 2710 of cells 2704a, 2704d, while allowing a degree of flexion of the cells 2704a, 2704b, 2704c, 2704d with respect to the module 2708 without causing damage to any components. Each side of the module 2708 also includes a straight conductive flange 2711 by which additional electrical connections are made. Referring to the circuit diagram, the bent conductive flanges 2709 provide B- and B+ contacts with the poles 2710 of cells 2704a and 2704d, respectively, and the straight conductive flanges 2711 provide Out B and Out A contacts, respectively. The pinout 2730 of the module 2708 provides Gate Q1-Q4, Temp Sense, Current Sense B-, and Current Sense Out A contacts. The module 2708 is thus manufactured as a single, protected component and soldered onto the top side of the assembly 2700, with current sensors constantly calibrated during use.

In one example: a battery assembly, comprising: a plurality of battery cells each comprising a pair of poles; a printed circuit board disposed adjacent to the plurality of battery cells and electrically coupled to a pole of the pair of poles of each of the plurality of battery cells; a plurality of switches disposed on or adjacent to the printed circuit board each electrically coupled between the pair of poles of an associated battery cell of the plurality of battery cells; and a controller disposed on the printed circuit board and electrically coupled to the plurality of switches; wherein the controller and the plurality of switches are operable for controlling the voltage provided by each of the plurality of battery cells. The battery assembly, further comprising one or more sensors disposed on the printed circuit board. The battery assembly, further comprising a contact disposed on the printed circuit board adapted to couple the printed circuit board to an adjacent printed circuit board associated with another plurality of battery cells of another battery assembly. The battery assembly, wherein the printed circuit board and the plurality of switches are electrically coupled to the pole of the pair of poles of each of the plurality of battery cells via a plurality of bus bars disposed one or more of above and below the printed circuit board. The battery assembly, further comprising a short busbar electrically coupled between the pole of the pair of poles of selected of the plurality of battery cells. The battery assembly, further comprising an insulating layer disposed on an upper surface of the short busbar electrically coupled between the pole of the pair of poles of selected of the plurality of battery cells. The battery assembly, wherein the plurality of switches are disposed in a module disposed adjacent to the printed circuit board. The battery assembly, wherein the module is disposed within or adjacent to a frame manufactured in the printed circuit board. The battery assembly, wherein the module comprises one or more conductive flanges disposed on either side thereof adapted to make electrical connections with the plurality of switches. The battery assembly, wherein selected of the one or more conductive flanges comprise a bent conductive flange adapted to electrically connect the plurality of switches to the pole of the pair of poles of selected of the plurality of battery cells and provide clearance between the module and the pole of the pair of poles of other of the plurality of battery cells.

Although the present disclosure is illustrated and described herein with reference to illustrative embodiments and specific examples thereof, it will be readily apparent to those of ordinary skill in the art that other embodiments and examples may perform similar functions and/or achieve like results. All such equivalent embodiments and examples are within the spirit and scope of the present disclosure, are contemplated thereby, and are intended to be covered by the following non-limiting claims for all purposes.

## Claims

1. A battery assembly, comprising:
a battery cell comprising a pair of poles;
a printed circuit board disposed adjacent to the battery cell and electrically coupled to a pole of the pair of poles;
an elongated busbar electrically coupled between the printed circuit board and another pole of the pair of poles;
a switch disposed on the printed circuit board and electrically coupled between the pair of poles; and
a controller disposed on the printed circuit board and electrically coupled to the switch;
wherein the controller and the switch are operable for controlling the voltage provided by the battery cell.

2. The battery assembly of claim 1, further comprising a power supply disposed on the printed circuit board.

3. The battery assembly of claim 1, further comprising one or more sensors disposed on the printed circuit board.

4. The battery assembly of claim 1, further comprising a contact disposed on the printed circuit board adapted to couple the printed circuit board to an adjacent printed circuit board associated with another battery cell of another battery assembly.

5. The battery assembly of claim 1, wherein the printed circuit board is integrated into a casing of the battery cell.

6. A battery assembly, comprising:
a pair of battery cells each comprising a pair of poles;
a printed circuit board disposed adjacent to the pair of battery cells and electrically coupled to a pole of the pair of poles of each of the pair of battery cells;
a pair of switches disposed on the printed circuit board each electrically coupled between the pair of poles of an associated battery cell of the pair of battery cells; and
a controller disposed on the printed circuit board and electrically coupled to the pair of switches;
wherein the controller and the pair of switches are operable for controlling the voltage provided by each of the pair of battery cells.

7. The battery assembly of claim 6, further comprising a short busbar electrically coupled between another pole of the pair of poles of each of the pair of battery cells and electrically coupled to the printed circuit board.

8. The battery assembly of claim 6, further comprising a power supply disposed on the printed circuit board.

9. The battery assembly of claim 6, further comprising one or more sensors disposed on the printed circuit board.

10. The battery assembly of claim 6, further comprising a contact disposed on the printed circuit board adapted to couple the printed circuit board to an adjacent printed circuit board associated with another pair of battery cells of another battery assembly.

11. The battery assembly of claim 6, wherein the printed circuit board and the pair of switches are electrically coupled to the pole of the pair of poles of each of the pair of battery cells via a plurality of bus bars disposed one or more of above and below the printed circuit board.

12. The battery assembly of claim 6, wherein the printed circuit board is disposed close enough to the pair of battery cells that the pair of battery cells act as a heatsink for the printed circuit board.

13. A battery assembly, comprising:
a plurality of battery cells each comprising a pair of poles;
a printed circuit board disposed adjacent to the plurality of battery cells and electrically coupled to a pole of the pair of poles of each of the plurality of battery cells;
a plurality of switches disposed on or adjacent to the printed circuit board each electrically coupled between the pair of poles of an associated battery cell of the plurality of battery cells; and
a controller disposed on the printed circuit board and electrically coupled to the plurality of switches;
wherein the controller and the plurality of switches are operable for controlling the voltage provided by each of the plurality of battery cells.

14. The battery assembly of claim 13, further comprising a short busbar electrically coupled between another pole of the pair of poles of selected of the plurality of battery cells and electrically coupled to the printed circuit board.

15. The battery assembly of claim 13, further comprising a power supply disposed on the printed circuit board.
